# EUROPÄISCHE PATENTSCHRIFT

(11) **EP 4 591 441 B1**
(45) Veröffentlichungstag und Bekanntmachung des Hinweises auf die Patenterteilung: **12.11.2025**
(21) Anmeldenummer: 24782772.8
(22) Anmeldetag: 12.09.2024
(51) Int. Cl.: H03K 17/18, H02H 3/087, H02H 3/24, H01S 3/09, H03K 17/785

(54) **ABSCHALTMODUL ZUR SICHEREN ABSCHALTUNG EINER GLEICHSPANNUNGSLAST**
DISCONNECTION MODULE FOR SAFELY DISCONNECTING A DC VOLTAGE LOAD
MODULE DE DÉCONNEXION POUR DÉCONNEXION SÉCURISÉE D'UNE CHARGE DE TENSION CC

(30) Priorität: 26.09.2023 DE 102023126125
(43) Veröffentlichungstag der Anmeldung: 30.07.2025
(73) Patentinhaber: Brightlight Laser Systems BLS GmbH, 12681 Berlin (DE)
(72) Erfinder: LÖHLE, Kai-Uwe, 12681 Berlin (DE)
(74) Vertreter: Werner, André
(86) Internationale Anmeldenummer: PCT/DE2024/150014
(87) Internationale Veröffentlichungsnummer: WO 2025/031542

(56) Entgegenhaltungen:
- WO-A1-2015/134635
- WO-A1-2017/196254
- DE-A1- 102006 030 448
- DE-A1- 102019 129 158
- CLAIRE CHANG AND TILDEN CHEN: "Why Pre-Charge Circuits are Necessary in High-VoltageSystems", 5 December 2021 (2021-12-05), XP002812705, Retrieved from the Internet <URL:https://www.ti.com/lit/ab/slvafb0/slvafb0.pdf> [retrieved on 20241205]

## Beschreibung

Die Erfindung betrifft ein zur sicheren Abschaltung einer Gleichspannungslast vorgesehenes Abschaltmodul, welches Schaltelemente auf Halbleiterbasis zur Abschaltung der Gleichspannungslast sowie eine Diagnoseeinheit zur Überwachung des Schaltzustandes der halbleiterbasierten Schaltelemente umfasst. Das Abschaltmodul eignet sich insbesondere zur sicheren Abschaltung der Spannungsversorgung von Laserstrahlquellen.

Zur Vermeidung von Gefahren beim Betrieb von Laseranlagen werden diese regelmäßig mit einer Reihe von Sensoren überwacht bzw. sind mit diversen Sicherheitsschaltern versehen. Zur Gewährleistung der Anlagensicherheit wird die Laseranlage bei Auslösung eines durch die Sensoren oder die Sicherheitsschalter ausgelösten Schaltsignals abgeschaltet, indem die Spannungsversorgung der Laserstrahlquelle unterbrochen wird. Um eine sichere, d. h. nachvollziehbare bzw. diagnostizierbare, Unterbrechung der Spannungsversorgung zu bewirken, werden üblicherweise Relais mit zwangsgeführten Kontakten als Schaltelemente zur Abschaltung der elektrischen Lasten genutzt. Über die Zwangsführung der Kontakte ist diagnostizierbar, ob die Lastkontakte offen sind. Hierbei erreicht man einen Diagnosedeckungsgrad von 90 % - 99 %. Die Diagnose des Schaltzustandes der Schaltelemente ermöglicht es, die Funktionalität der Abschaltvorrichtung zu überwachen und mithin eine sichere Abschaltung vorzunehmen. Nachteile der konventionellen Relaistechnik sind jedoch die verschleißbedingt begrenzte Lebensdauer (auf ca. 50.000 Schaltspiele) und der relativ große Bauraumbedarf.

Der grundsätzlich mögliche Ersatz mechanisch kontaktierender Relais durch Halbleiterbauteile erfordert mangels einer Diagnosemöglichkeit an den Lastkontakten alternative Überwachungselemente, um mit halbleiterbasierten Schaltelementen die Lastabschaltung in äquivalenter Weise wie bei mechanisch kontaktierenden Relais zu diagnostizieren und somit letztlich eine sichere Lastabschaltung vorzunehmen.

Aus DE 10 2019 129 158 A1 ist eine Schaltungsanordnungen bekannt, die mechanisch kontaktierende Relais durch Halbleiterrelais, sogenannte Solid State Relais (abgek.: SSR), ersetzt, wobei mittels einer Schaltungsanordnung der Schaltzustand der Halbleiterrelais überwacht wird, indem das Spannungspotential vor und nach jedem Halbleiterrelais erfasst, verglichen und auf Basis dieses Potentialvergleichs ein Steuersignal erzeugt wird. Mittels der Halbleiterrelais wird die Gleichspannungsversorgung eines mit einer Gleichspannung von 24 V oder 48 V versorgten Lasertreibers unterbrochen.

DE 10 2006 030 448 A1 offenbart eine Ausgangsschaltung für eine Ausgangsbaugruppe zum Schalten wenigstens einer angeschlossenen Last, wobei die Ausgangsschaltung sich durch einen einkanaligen Peripherieanschluss zum Anschließen der wenigstens einen Last auszeichnet, und wenigstens zwei zwischen einer Versorgungsspannung und dem Peripherieanschluss in Reihe geschaltete Treibermodule, insbesondere FET-Transistoren, umfasst, wobei jedes der Treibermodule über einen separaten Steuerkanal mit einer der Ausgangsbaugruppe zugeordneten Logik zur Ansteuerung der Treibermodule verbunden ist. Die Ausgangsschaltung kann zwei separat via Optokoppler angesteuerte halbleiterbasierte Abschaltkreise und ein Rückmeldesignal umfassen.

Chang, C.; Chen, T.: Why Pre-Charge Circuits are Necessary in High-Voltage Systems. Application Brief - Texas Instruments, 2021. URL: https://www.ti.com/document-viewer/lit/html/slvafb0 erläutert die Notwendigkeit der Vorladung bei Hochspannungskreisen. Ohne Vorladeschaltung kann es beim Schließen des Schützes zu Schweißungen kommen und es kann ein kurzer Lichtbogen entstehen. Eine Vorladeschaltung kann verwendet werden, um Belastungen und Schäden am elektrischen System zu verhindern, indem ein Widerstand und ein Schalter zur Begrenzung des Einschaltstroms implementiert werden.

Aufgabe der Erfindung ist es, ein Abschaltmodul zur sicheren Abschaltung elektrischer Lasten bereitzustellen, mit dem Gleichspannungslasten von max. 120 V und 100 A durch eine auf Halbleiterbauteilen basierenden Schaltung sicher abschaltbar sind. Hierbei soll ein Diagnosedeckungsgrad von 90 % - 99 % erreicht werden.

Diese Aufgabe wird durch ein Abschaltmodul mit den Merkmalen nach Anspruch 1 gelöst. Zweckmäßige Weiterbildungen der Erfindung sind in den Ansprüchen 2 bis 10 aufgeführt.

Nach Maßgabe der Erfindung dient das Abschaltmodul der sicheren Abschaltung einer Gleichspannungslast, die in Form einer Lastspannung als eingehende Eingangslastspannung zwischen einem Eingangslastpotential und einem lastseitigen Massepotential und als abgehende Ausgangslastspannung zwischen einem Ausgangslastpotential und dem lastseitigen Massepotential an einem Lastkreis des Abschaltmoduls anliegt. Das Abschaltmodul ist eingerichtet, bei Unterbrechung mindestens eines am Abschaltmodul anliegenden Schaltsignals den Lastkreis mittels einer halbleiterbasierten (d. h. einer Halbleiterbauteile als Schaltelemente aufweisenden) Abschalteinheit durch Unterbrechung der Verbindung von Eingangslastpotential und Ausgangslastpotential abzuschalten sowie mindestens ein die Lastabschaltung kenntlich machendes Rückmeldesignal auszugeben.

Das Abschaltmodul weist erfindungsgemäß die in den Lastkreis eingebundene halbleiterbasierte Abschalteinheit, eine Ansteuerungseinheit, an der das oder die Schaltsignale eingehen, eine Diagnoseeinheit, an der das oder die Rückmeldesignale ausgehen, sowie eine an eine Versorgungsspannung angeschlossene Spannungsversorgungseinheit zur Spannungsversorgung der Einheiten des Abschaltmoduls auf. Alle elektronischen Schalterelemente bzw. -bauteile des Abschaltmoduls sind Halbleiterbauteile, d. h., es sind keine mechanisch kontaktierenden Relais oder Schütze im Abschaltmodul integriert.

Die Abschalteinheit umfasst einen ersten und einen zweiten Abschaltkreis sowie einen Ladekreis. Die Abschalteinheit ist hierbei derart in den Lastkreis des Abschaltmoduls eingebunden, dass die Verbindung zwischen dem Eingangslastpotential und dem Ausgangslastpotential eine über die beiden Abschaltkreise geschaltete Hauptverbindung und eine parallel über den Ladekreis geschaltete Nebenverbindung umfasst.

Der erste und der zweite Abschaltkreis weisen jeweils eine Halbleiterschaltung, d. h. eine auf Halbleiterschaltern aufbauende Schaltung, mit mindestens einem Halbleiterschalter auf. Der jeweilige Halbleiterschalter ist vorzugsweise ein Metall-Oxid-Halbleiter-Feldeffekttransistor (abgek.: MOSFET). Metall-Oxid-Halbleiter-Feldeffekttransistoren sind bekannte elektronische Halbleiter-Bauelemente elektronischer Schaltungen. Der oder die Metall-Oxid-Halbleiter-Feldeffekttransistoren werden nachfolgend mit dem etablierten Kürzel MOSFET (engl. abgek. für: metal-oxide-semiconductor field-effect transistor) bezeichnet. Ferner können als Halbleiterschalter auch Bipolartransistoren, zum Beispiel Bipolartransistoren mit isolierter Gate-Elektrode (abgk. IGBT, engl. abgek. für: insulated-gate bipolar transistor), verwendet werden. Grundsätzlich sind alle ähnlich wirkenden Halbleiterbauelemente, d. h. insbesondere Transistorbauelemente, als Halbleiterschalter einsetzbar.

Die Hauptverbindung zwischen dem Eingangslastpotential und dem Ausgangslastpotential ist durch die in Reihe geschalteten Halbleiterschaltungen des ersten Abschaltkreises und des zweiten Abschaltkreises gebildet. Jede der Halbleiterschaltungen des ersten Abschaltkreises und des zweiten Abschaltkreises weist vorzugsweise jeweils mehrere, parallel geschaltete Halbleiterschalter, insbesondere jeweils zwei, drei oder vier parallel geschaltete Halbleiterschalter (zum Beispiel MOSFETs), auf. Die Parallelschaltung erfolgt zur verbesserten Lastverteilung und damit zur besseren Verteilung der thermischen Beanspruchung. In der Hauptverbindung zwischen der Halbleiterschaltung des ersten Abschaltkreises und der Halbleiterschaltung des zweiten Abschaltkreises liegt ein Zwischenschalterpotential an.

Der Ladekreis umfasst mindestens einen Halbleiterschalter und mindestens einen Leistungswiderstand, die in Reihe geschaltet die Nebenverbindung zwischen dem Eingangslastpotential und dem Ausgangslastpotential bilden. In der Nebenverbindung zwischen dem mindestens einen Halbleiterschalter und dem oder den Leistungswiderständen des Ladekreises liegt ein Ladespannungspotential an.

Die Ansteuerungseinheit weist einen Ansteuerungseingangskreis, eine erste Abschaltsteuerung zur Ansteuerung der ersten Abschalteinheit, eine zweite Abschaltsteuerung zur Ansteuerung der zweiten Abschalteinheit sowie eine Ladekreisansteuerung zur Ansteuerung des Ladekreises auf. Das bzw. die Schaltsignale gehen erfindungsgemäß in Form eines ersten und eines zweiten Schaltsignals am Ansteuerungseingangskreis ein, d. h., die Ansteuerungseinheit bzw. der Ansteuerungseingangskreis verfügen über die entsprechenden Eingänge. Der Ansteuerungseingangskreis ist ferner zur Verarbeitung der Schaltsignale eingerichtet.

Der oder die Halbleiterschalter der Halbleiterschaltung des ersten und des zweiten Abschaltkreises sind zur Steuerung der Aktivierung oder Sperrung der Hauptverbindung über jeweils einen Optokoppler an die jeweils zugeordnete Abschaltsteuerung angeschlossen, d. h., der erste Abschaltkreis an die erste Abschaltsteuerung und der zweite Abschaltkreis an die zweite Abschaltansteuerung.

Die erste Abschaltsteuerung und die zweite Abschaltsteuerung sind eingerichtet, die Hauptverbindung zu aktivieren, wenn beide an der Ansteuerungseinheit eingehenden Schaltsignale anliegen und die Spannungsdifferenz zwischen dem Eingangslastpotential und dem Ausgangslastpotential einen vorgegebenen Schwellwert unterschreitet. Die Halbleiterschaltung des ersten Abschaltkreises ist hierbei aktiviert, wenn das erste Schaltsignal anliegt bzw. aktiv ist und die Spannungsdifferenz zwischen dem Eingangslastpotential und dem Ausgangslastpotential den vorgegebenen Schwellwert unterschreitet, die Halbleiterschaltung des zweiten Abschaltkreises ist aktiviert, wenn das zweite Schaltsignal anliegt bzw. aktiv ist und die Spannungsdifferenz zwischen dem Eingangslastpotential und dem Ausgangslastpotential den vorgegebenen Schwellwert unterschreitet. Die Hauptverbindung ist folglich nur dann aktiv, wenn die in Reihe geschalteten Halbleiterschaltungen der ersten und der zweiten Abschaltsteuerung gleichzeitig aktiv sind.

Ferner ist der Halbleiterschalter des Ladekreises zur Steuerung der Aktivierung oder Sperrung der Nebenverbindung über einen Optokoppler an die Ladekreisansteuerung angeschlossen.

Die Ladekreisansteuerung ist eingerichtet, die Nebenverbindung durch Ansteuerung des Optokopplers des Ladekreises zu aktivieren, wenn beide an der Ansteuerungseinheit eingehenden Schaltsignale anliegen, d. h., wenn beide Schaltsignale aktiv sind.

Das oder die Rückmeldesignale gehen erfindungsgemäß als ein erstes und ein zweites Rückmeldesignal von der Diagnoseeinheit aus, d. h., die Diagnoseeinheit verfügt über entsprechende Ausgänge. Hierzu umfasst die Diagnoseeinheit einen ersten Diagnosekanal zur Ausgabe des ersten Rückmeldesignals und einen zweiten Diagnosekanal zur Ausgabe des zweiten Rückmeldesignals.

Der erste Diagnosekanal ist eingerichtet, über das erste Rückmeldesignal eine ordnungsgemäße Abschaltung des Lastkreises zu signalisieren, wenn
- die Spannungsdifferenz zwischen dem Ladespannungspotential und dem Ausgangslastpotential einen vorgegebenen Schwellwert überschreitet, und
- die Spannungsdifferenz zwischen dem Eingangslastpotential und dem Zwischenschalterpotential einen vorgegebenen Schwellwert überschreitet, und
- die Spannungsdifferenz zwischen dem Ausgangslastpotential und dem lastseitigen Massepotential einen vorgegebenen Schwellwert unterschreitet.

Der zweite Diagnosekanal ist eingerichtet, über das zweite Rückmeldesignal eine ordnungsgemäße Abschaltung des Lastkreises zu signalisieren, wenn
- die Spannungsdifferenz zwischen dem Ladespannungspotential und dem Ausgangslastpotential einen vorgegebenen Schwellwert überschreitet, und
- die Spannungsdifferenz zwischen dem Zwischenschalterpotential und dem Ausgangslastpotential einen vorgegebenen Schwellwert überschreitet, und
- die Spannungsdifferenz zwischen dem Ausgangslastpotential und dem lastseitigen Massepotential einen vorgegebenen Schwellwert unterschreitet.

Das erfindungsgemäße Abschaltmodul ermöglicht durch die Verwendung der Halbleiterschalter in den Halbleiterschaltungen des ersten und zweiten Abschaltkreises die Lastschaltung ohne Verwendung von mechanisch kontaktierenden Relais. Die halbleiterbasierten Schaltungen und Schaltelemente des Abschaltmoduls erfordern signifikant weniger Bauraum als mechanisch kontaktierenden Relais; sie ermöglichen zudem eine deutlich höhere Zahl an Schaltspielen.

Durch den in die Abschalteinheit integrierten Ladekreis wird der Lastkreis im Einschaltfall vorgeladen; hierdurch wird die Belastung der Halbleiterschalter der beiden Abschaltkreise im Einschaltfall beschränkt, d. h. Einschaltüberlastungen der Halbleiterschalter in den Abschaltkreisen vermieden.

Die kombinierte Diagnoseeinheit signalisiert die ordnungsgemäße Abschaltung der Gleichspannungslast, indem eine Funktionsdiagnose der verschiedenen Baueinheiten des Abschaltmoduls vorgenommen wird; die dabei generierten Informationen werden verknüpft und in Form der beiden Rückmeldesignale ausgegeben. Hierdurch wird mittels des erfindungsgemäßen Abschaltmoduls, welches die Abschaltung der Gleichspannungslast durch deren Halbleiterbauelemente, d. h. die Halbleiterschalter, in der Abschalteinheit vornimmt, ein Diagnosedeckungsgrad von 90 % - 99 % erreicht, d. h. ein Diagnosedeckungsgrad, der dem etablierter Kontaktrelais-Schaltungen entspricht.

Gemäß einer Ausgestaltung weist die Abschalteinheit des erfindungsgemäßen Abschaltmoduls ferner einen ersten Entladekreis und einen zweiten Entladekreis auf; zudem besitzt die Ansteuerungseinheit eine erste Entladekreisansteuerung zur Ansteuerung des ersten Entladekreises sowie eine zweite Entladekreisansteuerung zur Ansteuerung des zweiten Entladekreises.

Der erste Entladekreis umfasst mindestens einen Halbleiterschalter und mindestens einen Leistungswiderstand, die in Reihe geschaltet eine erste Entladeverbindung zwischen dem Ausgangslastpotential und dem lastseitigen Massepotential bilden, wobei der Halbleiterschalter des ersten Entladekreises zur Steuerung der Aktivierung oder Sperrung der ersten Entladeverbindung über einen Optokoppler an die erste Entladekreisansteuerung angeschlossen ist. Die erste Entladekreisansteuerung ist eingerichtet, die erste Entladeverbindung durch Ansteuerung des Optokopplers des ersten Entladekreises zu aktivieren, wenn das an der Ansteuerungseinheit eingehende erste Schaltsignal unterbrochen, d. h. inaktiv, ist.

Der zweite Entladekreis ist vergleichbar zum ersten Entladekreis aufgebaut, d. h., der zweite Entladekreis umfasst mindestens einen Halbleiterschalter und mindestens einen Leistungswiderstand, die in Reihe geschaltet eine zweite, parallel zur ersten Entladeverbindung geschaltete Entladeverbindung zwischen dem Ausgangslastpotential und dem lastseitigen Massepotential bilden, wobei der Halbleiterschalter des zweiten Entladekreises zur Steuerung der Aktivierung oder Sperrung der zweiten Entladeverbindung über einen Optokoppler an die zweite Entladekreisansteuerung angeschlossen ist. Die zweite Entladekreisansteuerung ist eingerichtet, die zweite Entladeverbindung durch Ansteuerung des Optokopplers des zweiten Entladekreises zu aktivieren, wenn das an der Ansteuerungseinheit eingehende zweite Schaltsignal unterbrochen, d. h. inaktiv, ist.

Die Entladekreise werden nach dem Abschalten der Abschaltkreise aktiviert. Im Fehlerfall limitieren die Entladekreise die Ausgangslastspannung, indem Strom über die Entladekreise abgeführt wird. Vorzugsweise sind die Größen der Leistungswiderstände im ersten Entladekreis und im zweiten Entladekreis so bemessen, dass die aktivierten Entladeverbindungen die Ausgangslastspannung auf ein Drittel der Eingangslastspannung reduzieren. Dies wird zum Beispiel erreicht, indem die Leistungswiderstände im ersten Entladekreis und im zweiten Entladekreis gemeinsam einen halb so niedrigen Widerstandswert aufweisen wie die Leistungswiderstände im Ladekreis. Sind Laserdioden an die Ausgangslastspannung angeschlossen, kann durch die Reduktion der Ausgangslastspannung auf ein gegenüber der Eingangslastspannung ausreichend niedriges Niveau erreicht werden, dass die Laserdioden keine Strahlung mehr emittieren. Wenn die Ausgangslastspannung auf ein Drittel der Eingangslastspannung reduziert wird, ist dies regelmäßig der Fall.

Es kann ferner vorgesehen sein, dass die Abschalteinheit einen Ausfallschutzkreis mit einer Ausfallentladeverbindung zwischen dem Ausgangslastpotential und dem lastseitigen Massepotential aufweist, wobei die Ausfallentladeverbindung mindestens einen Leistungswiderstand oder zwei parallel geschaltete Leistungswiderstände aufweist. Dieser bzw. diese zusätzlichen Entladewiderstände entladen den Lastkreis bei Spannungsausfall der Versorgungsspannung der Spannungsversorgungseinheit.

Gemäß einer weiteren Ausgestaltung des Abschaltmoduls weist die Ansteuerungseinheit ferner einen an die zweite Abschaltansteuerung angeschlossenen Überlastschutzkreis auf, der eingerichtet ist, die zweite Abschaltansteuerung zu deaktivieren, wenn die Versorgungsspannung der Spannungsversorgungseinheit unter einem vorgegebenen Schwellwert fällt. Hierdurch werden die Abschaltschaltkreise bei Schwächung der Versorgungsspannung geschützt.

Die Spannungsversorgungseinheit weist vorzugsweise einen ersten Spannungswandler zur Wandlung der Versorgungsspannung in eine Steuerspannung, die insbesondere zur Spannungsversorgung der Ansteuerungseinheit und der Diagnoseeinheit dient, sowie weitere Spannungswandler zur Wandlung der Versorgungsspannung in potentialfreie Halbleiterschalter-Steuerungsspannungen auf. Die Halbleiterschalter-Steuerungsspannungen dienen zur Steuerung der Halbleiterschalter in den beiden Abschaltkreisen, im Ladekreis sowie in den beiden Entladekreisen. Vorzugsweise sind drei oder vier weitere Spannungswandler zur Wandlung der Versorgungsspannung in drei oder vier potentialfreie Halbleiterschalter-Steuerungsspannungen innerhalb der Spannungsversorgungseinheit vorgesehen. Bei allen genannten Spannungen handelt es sich um Gleichspannungen. Bevorzugt ist die Versorgungsspannung eine 24 V-Gleichspannung, die Steuerspannung eine 5 V-Gleichspannung und die Halbleiterschalter-Steuerungsspannungen jeweils eine 12 V-Gleichspannung.

In die Spannungsversorgungseinheit kann ferner ein Temperaturüberwachungskreis zur Temperaturüberwachung des Abschaltmoduls integriert sein, wobei der Temperaturüberwachungskreis zum Beispiel an dem ersten Spannungswandler angeschlossen ist. Der erste Spannungswandler weist hierzu einen Steuereingang auf, der mit dem Temperaturüberwachskreis verbunden ist. Über den Steuereingang erhält der erste Spannungswandler bei Temperaturüberlastung ein Signal und schaltet den Spannungswandler ab; hierdurch wird dann das Abschaltmodul deaktiviert. Der Temperaturüberwachungskreis umfasst vorzugsweise zwei oder drei parallel geschaltete Schaltkreise bzw. besteht aus diesen, wobei jeder dieser beiden Schaltkreise einen Heißleiter-Thermistor zur Temperaturerfassung aufweist. Der Temperaturüberwachungskreis ist vorzugsweise so ausgebildet, dass die Abschaltung bei Erreichen bzw. bei Überschreitung einer Abschalttemperatur von 80 °C stattfindet.

Vorzugsweise weist die Spannungsversorgungseinheit ferner einen Eingangsfilter zur Filterung elektromagnetischer Störungen der anliegenden Versorgungsspannung auf.

Gemäß einer Ausgestaltung des Abschaltmoduls weist der Ladekreis zwei Halbleiterschalter, d. h. einen ersten Ladekreis-Halbleiterschalter und einen zweiten Ladekreis-Halbleiterschalter, und mindestens einen Leistungswiderstand auf, wobei der erste Ladekreis-Halbleiterschalter, der zweite Ladekreis-Halbleiterschalter und der Leistungswiderstand in Reihe geschaltet die Nebenverbindung zwischen dem Eingangslastpotential und dem Ausgangslastpotential bilden. In der Nebenverbindung zwischen dem ersten Ladekreis-Halbleiterschalter und dem oder den Leistungswiderständen des Ladekreises liegt ein erstes Ladespannungspotential und zwischen dem ersten und dem zweiten Ladekreis-Halbleiterschalter liegt ein zweites Ladespannungspotential an.

Die Diagnoseeinheit weist bei Verwendung der vorstehend beschriebenen Ausgestaltung des zwei Halbleiterschalter umfassenden Ladekreises eine modifizierte Ansteuerung der Diagnosekanäle auf:
Bei Verwendung des Ladekreises mit zwei Halbleiterschaltern ist der erste Diagnosekanal eingerichtet, über das erste Rückmeldesignal eine ordnungsgemäße Abschaltung des Lastkreises zu signalisieren, wenn
- die Spannungsdifferenz zwischen dem ersten Ladespannungspotential und dem zweiten Ladespannungspotential einen vorgegebenen Schwellwert überschreitet, und
- die Spannungsdifferenz zwischen dem Eingangslastpotential und dem Zwischenschalterpotential einen vorgegebenen Schwellwert überschreitet, und
- die Spannungsdifferenz zwischen dem Ausgangslastpotential und dem lastseitigen Massepotential einen vorgegebenen Schwellwert unterschreitet.

Ferner ist bei Verwendung des Ladekreises mit zwei Halbleiterschaltern der zweite Diagnosekanal eingerichtet, über das zweite Rückmeldesignal eine ordnungsgemäße Abschaltung des Lastkreises zu signalisieren, wenn
- die Spannungsdifferenz zwischen dem zweiten Ladespannungspotential und dem Ausgangslastpotential einen vorgegebenen Schwellwert überschreitet, und
- die Spannungsdifferenz zwischen dem Zwischenschalterpotential und dem Ausgangslastpotential einen vorgegebenen Schwellwert überschreitet, und
- die Spannungsdifferenz zwischen dem Ausgangslastpotential und dem lastseitigen Massepotential einen vorgegebenen Schwellwert unterschreitet.

Die vorgegebenen Schwellwerte der Spannungsdifferenzen sind jeweils auf einen Wert im Bereich von 0,5 V bis 16 V, insbesondere auf 4 V ± 1 V, 8 V ± 1 V oder 14 V ± 1 V, eingestellt. Dies wird durch den Aufbau der Schaltungen, die Auswahl der elektronischen Bauteile und deren Einstellung bzw. Programmierung realisiert.

Die Erfindung ist nachfolgend anhand von Ausführungsbeispielen und mit Bezug auf die schematischen Zeichnungen näher erläutert, wobei gleiche oder ähnliche Merkmale mit gleichen Bezugszeichen versehen sind; dazu zeigen
- Fig. 1:: eine erste Ausführung des Abschaltmoduls in Blockschaltbilddarstellung;
- Fig. 2:: den Schaltplan der Abschalteinheit der ersten Ausführung des Abschaltmoduls mit Details zu den Abschaltkreisen;
- Fig. 3:: den Schaltplan der Abschalteinheit der ersten Ausführung des Abschaltmoduls mit Details zum Ladekreis und zum ersten Entladekreis;
- Fig. 4:: den Schaltplan der Abschalteinheit der ersten Ausführung des Abschaltmoduls mit Details zum Ladekreis und zum zweiten Entladekreis;
- Fig. 5:: den Schaltplan des Ansteuerungseingangskreises;
- Fig. 6:: die Schaltpläne der Abschaltansteuerungen;
- Fig. 7:: die Schaltpläne der Ladekreis- und der Entladekreisansteuerungen;
- Fig. 8:: die Schaltpläne der Spannungsversorgungseinheit der ersten Ausführung des Abschaltmoduls mit Details zum ersten, die Steuerspannung erzeugenden Spannungswandler sowie zur Temperaturüberwachung;
- Fig. 9:: die Schaltpläne der Spannungsversorgungseinheit der ersten Ausführung des Abschaltmoduls mit Details zu den die potentialfreien Halbleiterschalter-Steuerungsspannungen erzeugenden Spannungswandlern;
- Fig. 10:: den Schaltplan des ersten Diagnosekanals der Diagnoseeinheit der ersten Ausführung des Abschaltmoduls;
- Fig. 11:: den Schaltplan des zweiten Diagnosekanals der Diagnoseeinheit der ersten Ausführung des Abschaltmoduls;
- Fig. 12:: eine zweite Ausführung des Abschaltmoduls in Blockschaltbilddarstellung;
- Fig. 13:: den Schaltplan der Abschalteinheit der zweiten Ausführung des Abschaltmoduls mit Details zum Ladekreis und zum ersten Entladekreis;
- Fig. 14:: die Schaltpläne der Spannungsversorgungseinheit der zweiten Ausführung des Abschaltmoduls mit Details zum ersten, die Steuerspannung erzeugenden Spannungswandler sowie zur Temperaturüberwachung;
- Fig. 15:: die Schaltpläne der Spannungsversorgungseinheit der ersten Ausführung des Abschaltmoduls mit Details zu den die potentialfreien Halbleiterschalter-Steuerungsspannungen erzeugenden Spannungswandlern;
- Fig. 16:: den Schaltplan des ersten Diagnosekanals der Diagnoseeinheit der zweiten Ausführung des Abschaltmoduls; und
- Fig. 17:: den Schaltplan des zweiten Diagnosekanals der Diagnoseeinheit der zweiten Ausführung des Abschaltmoduls.

In den nachfolgenden Schaltbildern und Schaltplänen sind die Einzelbauelemente mit den etablierten Schaltzeichen dargestellt und mit den üblichen Kürzeln bezeichnet, d. h.: C für Kondensatoren, D für Dioden, DCDC für (Gleichstrom-)Spannungswandler, IC für einen integrierten Schaltkreis (zum Beispiel ein Logikbauteil), L für Spulen, M für Metall-Oxid-Halbleiter-Feldeffekttransistoren (MOSFETs), NTC für Heißleiter-Thermistoren, Q für Transistoren und R für Widerstände. Die dem Kürzel jeweils folgende Nummerierung dient zur Unterscheidung und genauen Identifizierung des jeweiligen Bauelements im Schaltplan. Mit dem Kürzel K sind die Anschlussklemmen der Lastspannung und mit dem Kürzel X alle weiteren Anschlüsse bezeichnet.

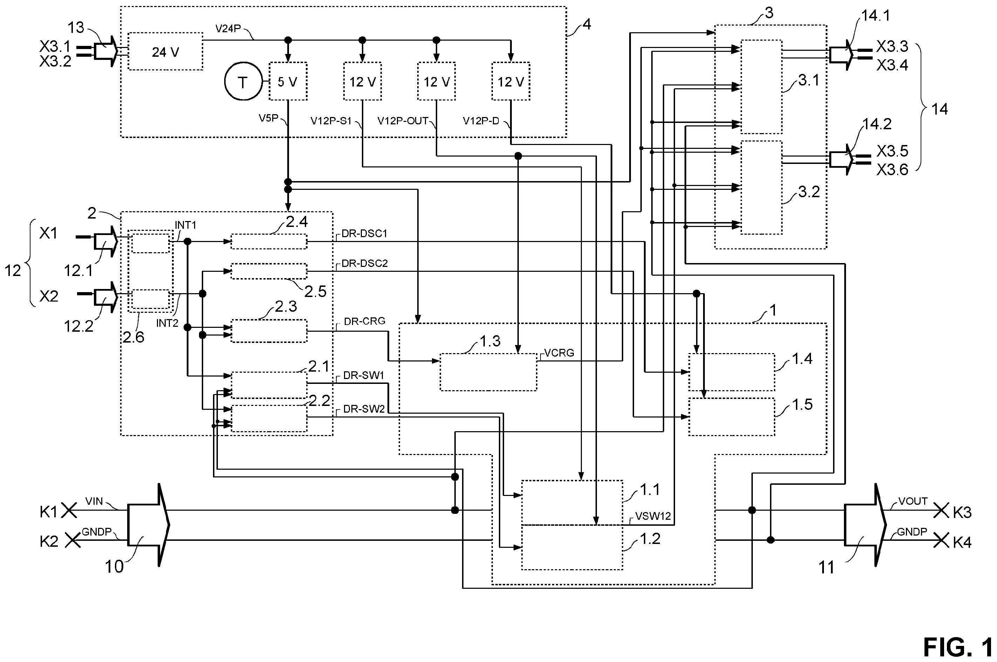

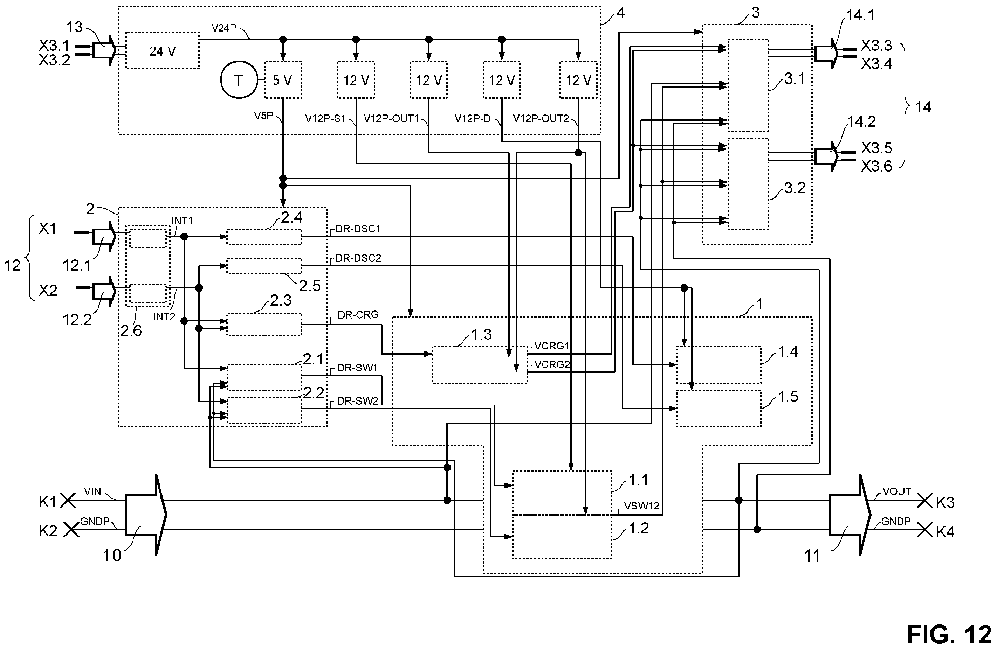

Die Fig. 1 bis 11 zeigen eine erste Ausführung des Abschaltmoduls und die Fig. 12 bis 17 eine zweite Ausführung des Abschaltmoduls, wobei die zweite Ausführung sich mit der ersten Ausführung weitestgehend deckt. Hinsichtlich der zweiten Ausführung des Abschaltmodus werden insofern nur deren Besonderheiten näher erläutert; für nicht beschriebene Einzelheiten wird auf die Beschreibung der ersten Ausführung des Abschaltmoduls verwiesen.

In Fig. 1 sind die einzelnen Baugruppen des Abschaltmoduls der ersten Ausführung, nämlich der Abschalteinheit 1, die Ansteuerungseinheit 2, die Diagnoseeinheit 3 sowie die Spannungsversorgungseinheit 4 einschließlich ihrer jeweiligen untergeordneten Funktionseinheiten dargestellt.

Die Gleichspannungslast liegt in Form der Eingangslastspannung 10 am Abschaltmodul an und wird in Form der Ausgangslastspannung 11 am Abschaltmodul abgegriffen. Die Eingangslastspannung 10 wird über die Anschlussklemmen K1 und K2 angeschlossen, wobei das Eingangslastpotential VIN an der Anschlussklemme K1 und das lastseitige Massepotential GNDP an der Anschlussklemme K2 anliegen. Die Anschlussklemmen K3 und K4 bilden den Anschluss der Ausgangslastspannung 11, wobei das Ausgangslastpotential VOUT an der Anschlussklemme K3 und das lastseitige Massepotential GNDP an der Anschlussklemme K4 anliegen.

Die Schaltsignale 12 gehen an der Ansteuerungseinheit 2 ein, wobei über den Anschluss X1 das erste Schaltsignal 12.1 und über den Anschluss X2 das zweite Schaltsignal 12.2 am Ansteuerungseingangskreis 2.6 der Ansteuerungseinheit 2 anliegt. Im Ansteuerungseingangskreis 2.6 erfolgt die Verarbeitung des ersten Schaltsignals 12.1 zum ersten Schaltsignalpotential INT1 und des zweiten Schaltsignals 12.2 zum zweiten Schaltsignalpotential INT2. Das erste Schaltsignalpotential INT1 und das zweite Schaltsignalpotential INT2 gehen als Steuergrößen in die erste Abschaltansteuerung 2.1, die zweite Abschaltsteuerung 2.2, die Ladekreisansteuerung 2.3 sowie die erste Entladekreisansteuerung 2.4 und die zweite Entladekreisansteuerung 2.5 ein.

Die erste Abschaltansteuerung 2.1 verarbeitet das erste Schaltsignalpotential INT1 sowie das Eingangslastpotential VIN und das Ausgangslastpotential VOUT, um das erste Schaltsteuerungspotential DR-SW1 zu erzeugen. In vergleichbarer Weise verarbeitet die zweite Abschaltansteuerung 2.2 das zweite Schaltsignalpotential INT2 sowie das Eingangslastpotential VIN und das Ausgangslastpotential VOUT, um das zweite Schaltsteuerungspotential DR-SW2 zu erzeugen. Das erste Schaltsteuerungspotential DR-SW1 dient zur Ansteuerung des ersten Abschaltkreises 1.1; das zweite Schaltsteuerungspotential DR-SW2 dient entsprechend zur Ansteuerung des zweiten Abschaltkreises 1.2. Zwischen den beiden Abschaltkreises 1.1, 1.2 wird das Zwischenschalterpotential VSW12 abgegriffen.

Die Ladekreisansteuerung 2.3 verarbeitet das erste Schaltsignalpotential INT1 und das zweite Schaltsignalpotential INT2, um das Ladeansteuerungspotential DR-CRG zu erzeugen. Über das Ladeansteuerungspotential DR-CRG wird der Ladekreis 1.3 angesteuert. Am Ladekreis 1.3 wird das Ladespannungspotential VCRG abgegriffen.

Mittels der ersten Entladekreisansteuerung 2.4 werden durch Verarbeitung des ersten Schaltsignalpotentials INT1 das erste Entladeansteuerungspotential DR-DSC1 und mittels der zweiten Entladekreisansteuerung 2.5 durch Verarbeitung des zweiten Schaltsignalpotentials INT2 das zweite Entladeansteuerungspotential DR-DSC2 erzeugt. Das erste Entladeansteuerungspotential DR-DSC1 dient zur Ansteuerung des ersten Entladekreises 1.4; das zweite Entladeansteuerungspotential DR-DSC2 dient entsprechend zur Ansteuerung des zweiten Entladekreises 1.5.

Die Spannungsversorgung des Abschaltmoduls erfolgt mittels der Spannungsversorgungseinheit 4, an der die Versorgungsspannung 13 über die Anschlüsse X3.1, X3.2 anliegt. Die über einen Eingangsfilter gefilterte Versorgungspannung 13 in Höhe von 24 V, gekennzeichnet durch das Versorgungsspannungspotential V24P, wird über einen mit dem Temperaturüberwachungskreis T verbundenen ersten Spannungswandler in eine 5 V-Steuerspannung, gekennzeichnet durch das Steuerspannungspotential V5P, sowie über weitere Spannungswandler in die 12 V-Halbleiterschalter-Steuerspannungen, gekennzeichnet durch das erste Halbleiterschalter-Steuerpotential V12P-S1, das zweite Halbleiterschalter-Steuerpotential V12P-OUT und das dritte Halbleiterschalter-Steuerpotential V12P-D, gewandelt.

Die 5 V-Steuerspannung dient insbesondere zur Spannungsversorgung der Ansteuerungseinheit 2 und der Diagnoseeinheit 3; die 12 V-Halbleiterschalter-Steuerspannungen werden zur Schaltung der Halbleiterschalter (hier MOSFETs) im ersten Abschaltkreis 1.1, im zweiten Abschaltkreis 1.2, im Ladekreis 1.3 sowie im ersten Entladekreis 1.4 und im zweiten Entladekreis 1.5 verwendet.

Die Diagnoseeinheit 3 gibt die Rückmeldesignale 14 aus, wobei das erste, vom ersten Diagnosekanal 3.1 generierte Rückmeldesignal 14.1 an den Anschlüssen X3.3, X3.4 und das zweite, vom zweiten Diagnosekanal 3.2 generierte Rückmeldesignal 14.2 an den Anschlüssen X3.5, X3.6 abgreifbar sind.

Als Eingangssignale zur Erzeugung des ersten Rückmeldesignals 14.1 mittels des ersten Diagnosekanals 13.1 dienen das Ladespannungspotential VCRG, das Ausgangslastpotential VOUT, das Eingangslastpotential VIN, das Zwischenschalterpotential VSW12 sowie das lastseitige Massepotential GNDP; als Eingangssignale zur Erzeugung des zweiten Rückmeldesignals 14.2 gehen am zweiten Diagnosekanal 3.2 das Ladespannungspotential VCRG, das Ausgangslastpotential VOUT, das Zwischenschalterpotential VSW12 sowie das lastseitige Massepotential GNDP ein.

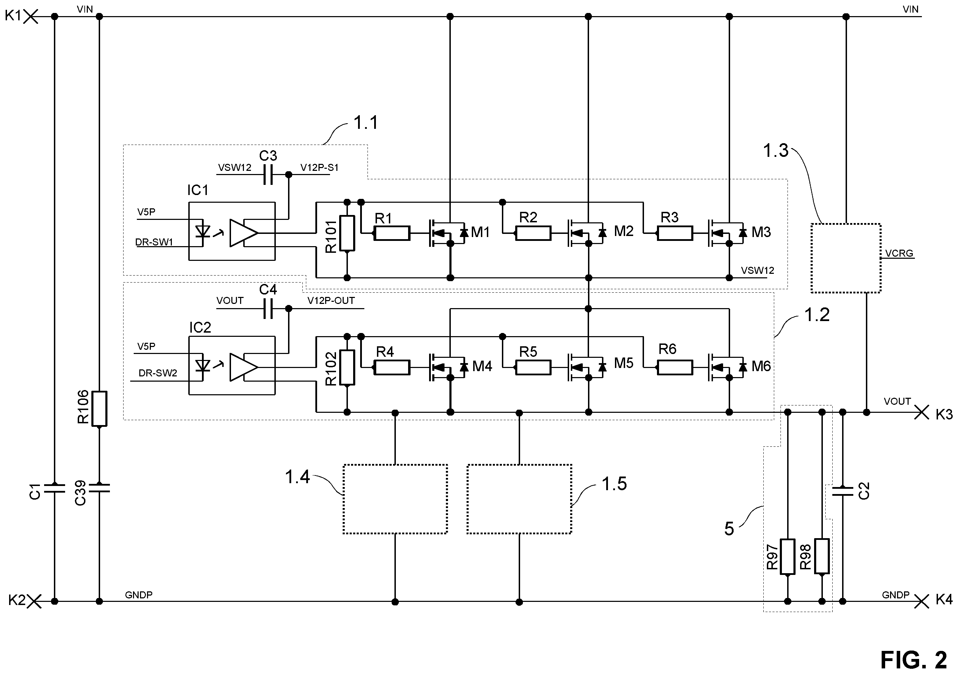

Gemäß dem in Fig. 2 dargestellten Schaltbild der Abschalteinheit 1 weisen die beiden Abschaltkreise 1.1, 1.2 jeweils eine Halbleiterschaltung aus jeweils drei parallel geschalteten N-Kanal MOSFETs als Halbleiterschalter auf. Im ersten Abschaltkreis 1.1 sind die drei MOSFETs mit M1, M2 und M3 und im zweiten Abschaltkreis 1.2 mit M4, M5 und M6 bezeichnet. Beide Halbleiterschaltungen sind in Reihe geschaltet und bilden die Hauptverbindung zwischen dem Eingangslastpotential VIN und dem Ausgangslastpotential VOUT, wobei zwischen den beiden Halbleiterschaltungen das Zwischenschalterpotential VSW12 abgegriffen wird. Die Ansteuerung der Halbleiterschalter (MOSFETs) erfolgt über die mit IC1 und IC2 bezeichneten Optokoppler, wobei am Optokoppler IC1 als Eingangssignal das erste Schaltsteuerungspotential DR-SW1 und am Optokoppler IC2 als Eingangssignal das zweite Schaltsteuerungspotential DR-SW2 anliegen. Die Widerstände R1, R2, R3, R4, R5, und R6 dienen als Gate-Vorwiderstände; die Widerstände R101 und R102 sorgen bei Ausfall der Versorgungsspannung für das sichere Abschalten der Halbleiterschalter (MOSFETs).

Neben dem detaillierten Aufbau der Schaltungen der beiden Abschaltkreise 1.1, 1.2 sind schematisch die Einbindung des Ladekreises 1.3 und der beiden Entladekreise 1.4, 1.5 in den Lastkreis des Abschaltmoduls dargestellt. Zudem ist der durch die beiden parallel geschalteten Widerstände R97, R98 gebildete Ausfallschutzkreis 5 hervorgehoben. Der Ausfallschutzkreis 5 dient dazu, den Lastkreis bei Ausfall der 24 V-Versorgungsspannung 13 zu entladen, wobei die Ausgangslastspannung 11 vorzugsweise auf ein Drittel der Eingangslastspannung 10 entladen wird.

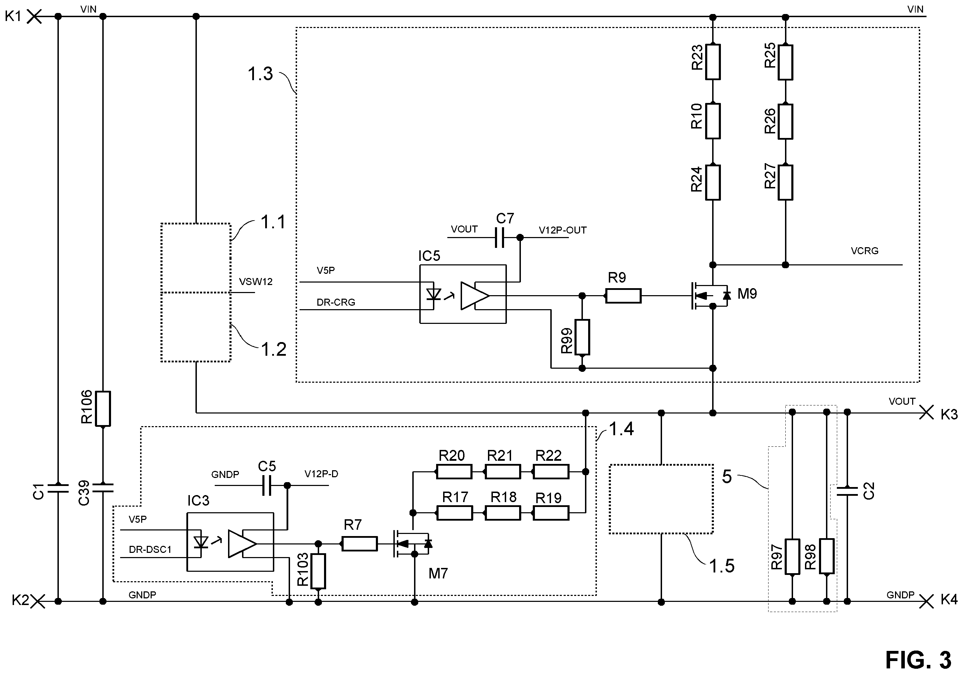

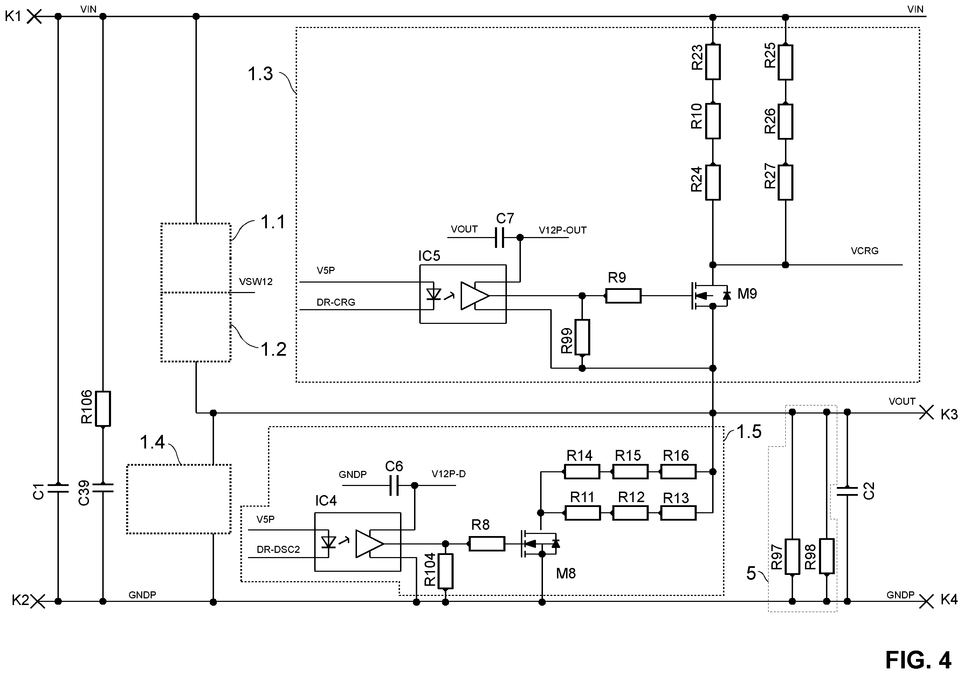

Die Fig. 3 und die Fig. 4 geben in einer mit Fig. 2 korrespondierenden Darstellung die beiden Abschaltkreise 1.1, 1.2 jeweils vereinfacht wieder; in Fig. 3 werden der detaillierte Aufbau der Schaltungen des Ladekreises 1.3 und des ersten Entladekreises 1.4 und in Fig. 4 der detaillierte Aufbau der Schaltungen des Ladekreises 1.3 und des zweiten Entladekreises 1.5 gezeigt.

Der Ladekreis 1.3 besitzt einen ähnlichen Aufbau wie die jeweiligen Abschaltkreise 1.1, 1.2, wobei der mit M9 bezeichnete MOSFET (Halbleiterschalter) des Ladekreises 1.3 über den mit IC5 gekennzeichneten Optokoppler angesteuert wird. Der Widerstand R9 bildet den Gate-Vorwiderstand und der Widerstand R99 den Abschaltwiderstand bei Spannungsausfall. Als Eingangssignal zur Steuerung des Ladekreis-Optokopplers IC5 dient das Ladeansteuerungspotential DR-CRG. Neben dem MOSFET M9 weist der Ladekreis 1.3 die Widerstandskaskade aus den Leistungswiderständen R10, R23, R24, R25, R26 und R27 auf. Der MOSFET M9 und diese Widerstandskaskade bildet die Nebenverbindung zwischen dem Eingangslastpotential VIN und dem Ausgangslastpotential VOUT. Zwischen dem MOSFET M9 und der Leistungswiderstandskaskade wird zudem das Ladespannungspotential VCRG abgegriffen.

Die Entladekreise 1.4, 1.5 werden nach Abschaltung der Abschaltkreise 1.1, 1.2 aktiviert; sie sind ähnlich dem Ladekreis 1.3 aufgebaut.

Der erste, in Fig. 3 dargestellte Entladekreis 1.4 weist den MOSFET M7 und die Widerstandskaskade aus den Widerständen R17, R18, R19, R20, R21 und R22 auf, die gemeinsam die ersten Entladeverbindung zwischen Ausgangslastpotential VOUT und dem lastseitigen Massepotential GNDP bilden. Die Ansteuerung des MOSFET M7 erfolgt über den mit IC3 gekennzeichneten Optokoppler; der Widerstand R7 bildet den Gate-Vorwiderstand und der Widerstand R103 den Abschaltwiderstand bei Spannungsausfall. Als Eingangssignal zur Steuerung des Entladekreis-Optokopplers IC3 dient das erste Entladeansteuerungspotential DR-DSC1.

Der zweite, in Fig. 4 dargestellte Entladekreis 1.5 weist den MOSFET M8 und die Widerstandskaskade aus den Widerständen R11, R12, R13, R14, R15 und R16 auf, die gemeinsam die zweite Entladeverbindung zwischen Ausgangslastpotential VOUT und dem lastseitigen Massepotential GNDP bilden. Die Ansteuerung des MOSFET M8 erfolgt über den mit IC4 gekennzeichneten Optokoppler; der Widerstand R8 bildet den Gate-Vorwiderstand und der Widerstand R104 den Abschaltwiderstand bei Spannungsausfall. Als Eingangssignal zur Steuerung des Entladekreis-Optokopplers IC4 dient das zweite Entladeansteuerungspotential DR-DSC2.

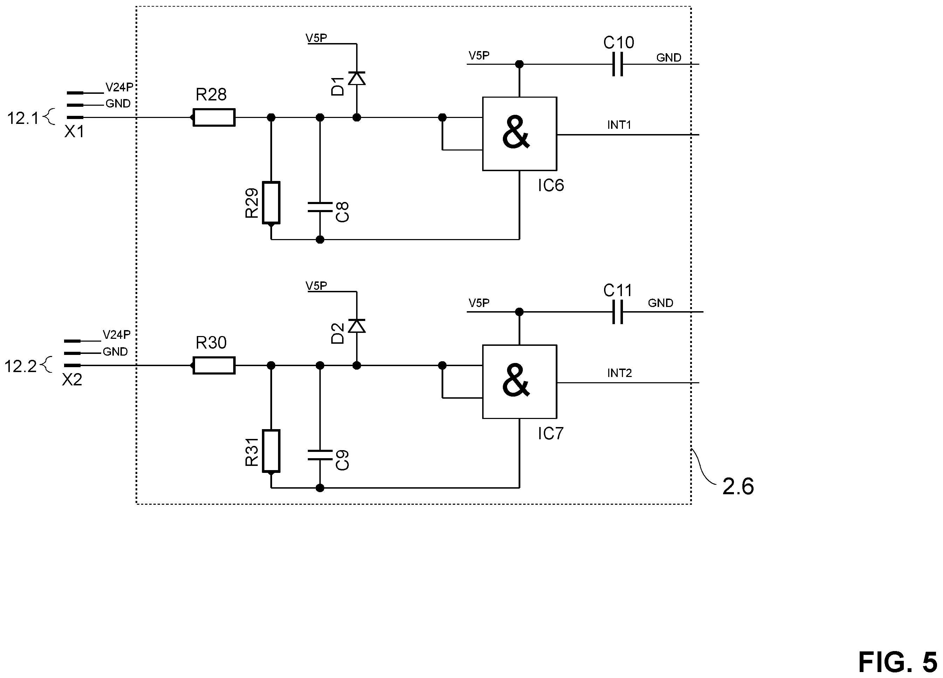

Der in Fig. 5 wiedergegebene Ansteuerungseingangskreis 2.6 umfasst zwei vergleichbar aufgebaute Schaltungen zur Verarbeitung des ersten, am Anschluss X1 eingehenden Schaltsignals 12.1 und des zweiten, am Anschluss X2 eingehenden Schaltsignals 12.2, die die UND-Gatter IC6, IC7 als Logikbausteine aufweisen. Beide Schaltsignale 12.1, 12.2 liegen als 24 V-Spannungen an und werden über jeweils einen Spannungsteiler auf 4,4 V herabgesenkt. Die Kondensatoren C8 und C9 schützen den Eingang vor hochfrequenten Störsignalen. Die Dioden D1 und D2 verhindern Überspannungen an den Logikbausteinen. Die Ausgabesignale des Ansteuerungseingangskreises 2.6 sind das erste, dem ersten Schaltsignal 12.1 zugeordnete Schaltsignalpotential INT1 und des zweite, dem zweiten Schaltsignal 12.2 zugeordnete Schaltsignalpotential INT2.

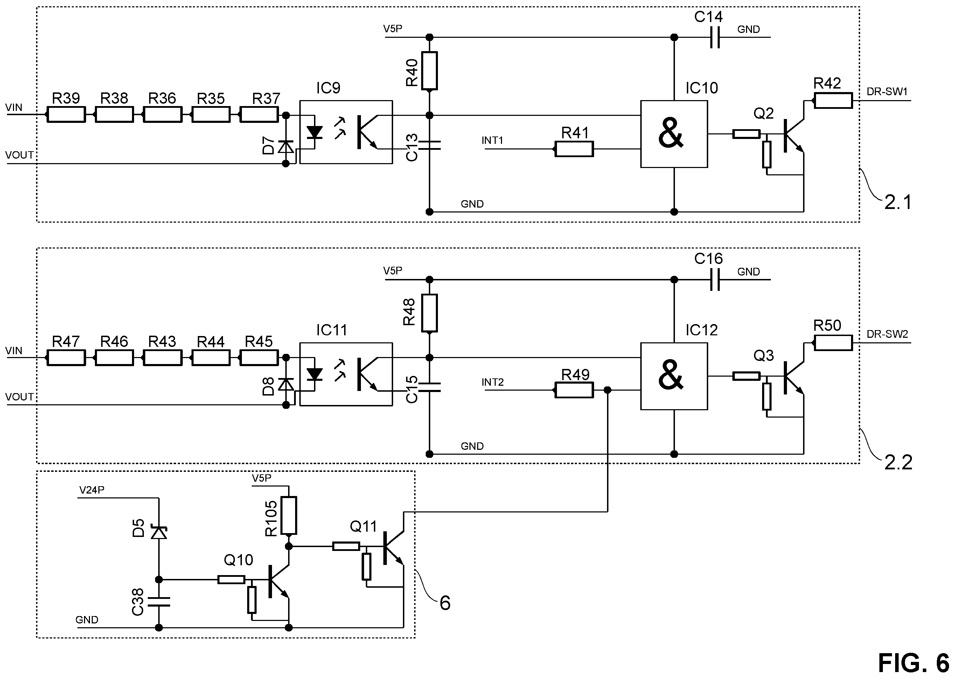

Die beiden in Fig. 6 gezeigten Abschaltansteuerungen 2.1, 2.2 weisen Logikbausteine in Form der UND-Gatter IC10 bzw. IC12 auf, deren jeweiliges Ausgangssignal die Transistoren Q2 bzw. Q3 ansteuert. In der ersten Abschaltansteuerung 2.1 gehen am UND-Gatter IC10 als Eingangssignale das Schaltsignalpotential INT1 sowie das vom Optokoppler IC9 herangeführte Signal, welches sich in Abhängigkeit des am Optokoppler IC9 anliegenden Eingangslastpotentials VIN und des Ausgangslastpotentials VOUT ergibt, ein. Das erste Schaltsteuerungspotential DR-SW1 ist dann aktiv, wenn das Schaltsignalpotential INT1 aktiv ist und wenn die Spannungsdifferenz zwischen dem Eingangslastpotential VIN und dem Ausgangslastpotential VOUT kleiner als 4 V ist. Die Schaltung der zweiten Abschaltansteuerung 2.2 ist äquivalent zur ersten Abschaltansteuerung 2.1 aufgebaut, wobei am UND-Gatter IC12 als Eingangssignale das Schaltsignalpotential INT2 sowie das vom Optokoppler IC11 herangeführte Signal, welches sich ebenfalls in Abhängigkeit des am Optokoppler IC9 anliegenden Eingangslastpotentials VIN und des Ausgangslastpotentials VOUT ergibt, eingehen. Das zweite Schaltsteuerungspotential DR-SW2 ist mithin dann aktiv, wenn das Schaltsignalpotential INT2 aktiv ist und wenn die Spannungsdifferenz zwischen dem Eingangslastpotential VIN und dem Ausgangslastpotential VOUT wiederum kleiner als 4 V ist. An dem Ausgang des UND-Gatters IC10 ist der NPN-Transistor Q2, an dem des UND-Gatters IC12 ist der NPN-Transistor Q3 angeschlossen. Das vom Transistor Q2 ausgehende Ausgangssignal der ersten Abschaltansteuerung 2.1 ist das erste Schaltsteuerungspotential DR-SW1; das vom Transistor Q3 ausgehende Ausgangssignal der zweiten Abschaltansteuerung 2.2 ist das zweite Schaltsteuerungspotential DR-SW2.

Die Widerstände R35, R36, R37, R38, R39 sowie R43, R44, R45, R46 und R47 dienen als Vorwiderstände. Die Widerstände R40 und R48 sind Pull-up-Widerstände; die Kondensatoren C13 und C15 dienen jeweils zur Signalstabilisierung.

An die zweite Abschaltansteuerung 2.2 ist zusätzlich der Überlastschutzkreis 6 angeschlossen, der ein Ansteuern bei Ausfall bzw. bei unzulässig hohem Abfall der 24 V-Versorgungsspannung 13 verhindert.

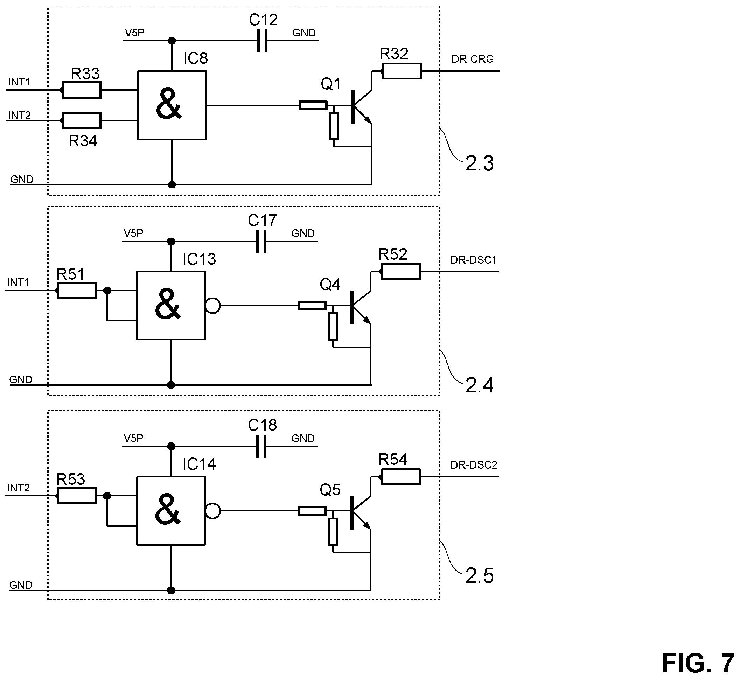

In Fig. 7 sind die Ladekreisansteuerung 2.3 sowie die erste Entladekreisansteuerung 2.4 und die zweite Entladekreisansteuerung 2.5 dargestellt. Diese Schaltungen sind in ähnlicher Weise aus jeweils einem Logikbaustein und dem am Ausgang des Logikbausteins angeschlossenen Transistor aufgebaut.

Die Ladekreisansteuerung 2.3 weist ein UND-Gatter IC8 als Logikbaustein auf, an dem eingangsseitig das erste Schaltsignalpotential INT1 und das zweite Schaltsignalpotential INT2 anliegen. Das vom NPN-Transistor Q1 ausgehende Ladeansteuerungspotential DR-CRG, mit dem der Ladekreis 1.3 angesteuert wird, ist aktiv, wenn sowohl das erste Schaltsignalpotential INT1 als auch das zweite Schaltsignalpotential INT2 aktiv sind.

Die beiden Entladekreisansteuerungen 2.4, 2.5 weisen als Logikbaustein jeweils ein NAND-Gatter, d. h. ein negatives UND-Gatter, auf. Die Entladekreisansteuerungen 2.4, 2.5 besitzen - wie im Fall der Ladekreisansteuerung 2.3 - zudem jeweils einen NPN-Transistor. Eingangsseitig an der ersten Entladekreisansteuerungen 2.4 liegt das erste Schaltsignalpotential INT1 an; ausgangsseitig ist die erste Entladekreisansteuerung 2.4 über das erste Entladeansteuerungspotential DR-DSC1 mit dem ersten Entladekreis 1.4 verbunden. Das erste Entladeansteuerungspotential DR-DSC1 ist aufgrund der Invertierung durch das NAND-Gatter aktiv, wenn das erste Schaltsignalpotential INT1 inaktiv, d. h. unterbrochen, ist. Eingangsseitig an der zweiten Entladekreisansteuerungen 2.5 liegt das Schaltsignalpotential INT2 an; ausgangsseitig ist die zweite Entladekreisansteuerung 2.5 über das zweite Entladeansteuerungspotential DR-DSC2 mit dem zweiten Entladekreis 1.5 verbunden. Das zweite Entladeansteuerungspotential DR-DSC2 ist infolge der Invertierung durch das NAND-Gatter aktiv, wenn das zweite Schaltsignalpotential INT2 inaktiv, d. h. unterbrochen, ist.

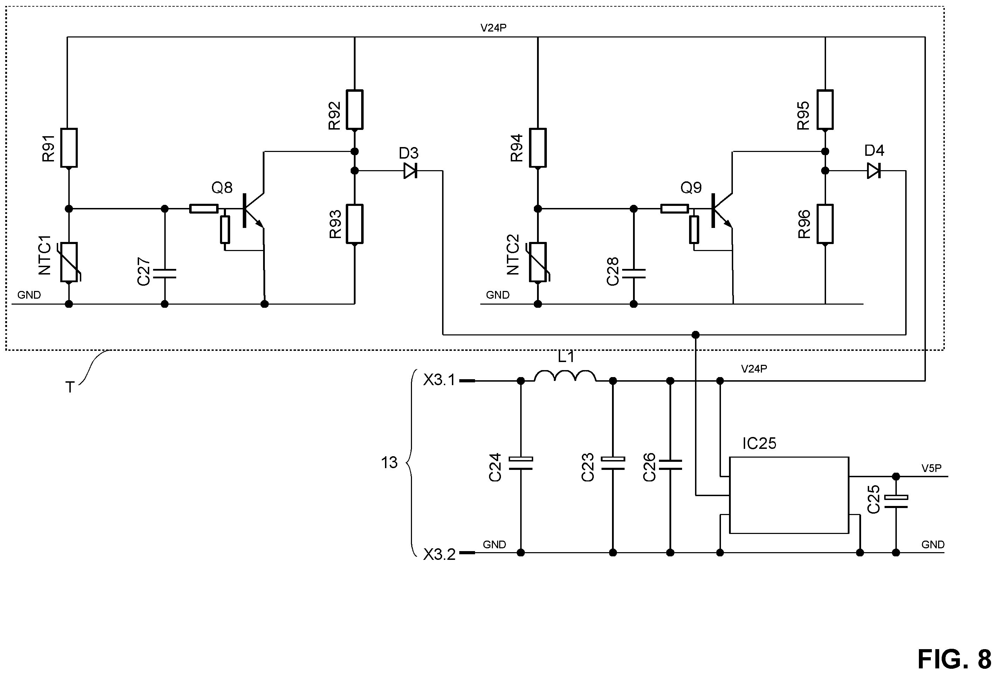

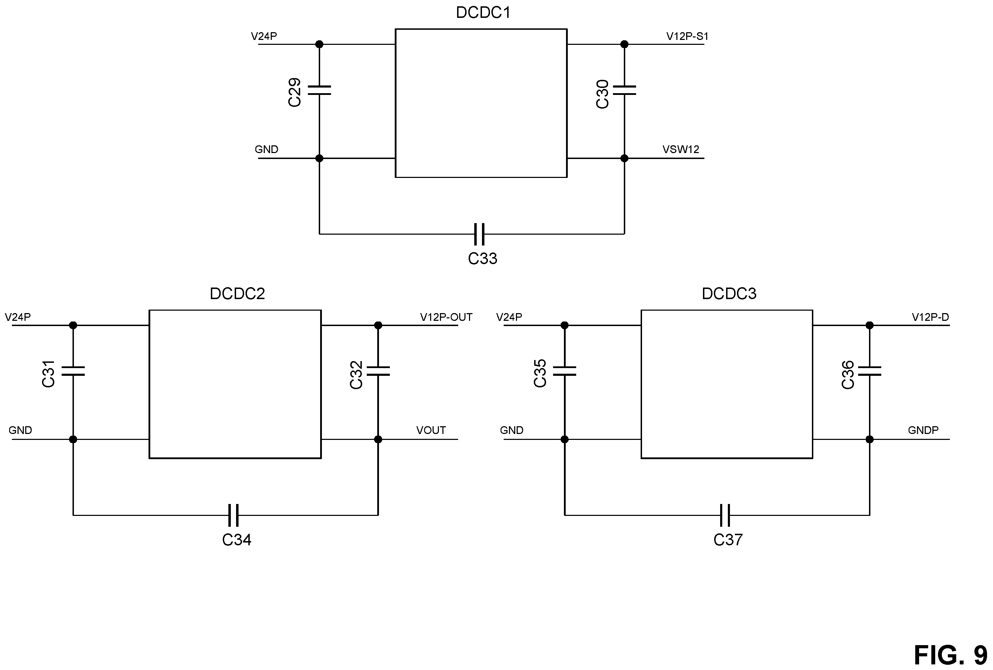

Die Schaltpläne bzw. die Komponenten der Spannungsversorgungseinheit 4 sind in den Fig. 8 und 9 wiedergegeben.

Die Fig. 8 zeigt die Anschlüsse X3.1, X3.2, über die das Abschaltmodul an die 24 V-Versorgungsspannung 13 angeschlossen ist. Zur Eingangsfilterung wird ein CLC-Glied (Kondensator C23-Spule L1-Kondensatoren C23, C26) benutzt. Zur Wandlung der gefilterten Versorgungsspannung 13, die zwischen dem Versorgungsspannungspotential V24P und dem steuerungsseitigen Massepotential GND anliegt, in die Steuerspannung, die zwischen dem Steuerspannungspotential V5P und dem steuerungsseitigen Massepotential GND anliegt, wird der erste Spannungswandler, d. h. der steuerbare Gleichspannungswandler IC25, benutzt. Der steuerbare Gleichspannungswandler IC25 ist über einen mit dem Temperaturüberwachungskreis T verbundenen Steuerungseingang abschaltbar. Der Temperaturüberwachungskreis T umfasst zwei parallel geschaltete Schaltkreise zur Temperaturabschaltung mit jeweils einem Heißleiter-Thermistor NTC. Jeder der Schaltkreise zur Temperaturabschaltung umfasst einen Spannungsteiler aus einem Vorwiderstand R91 bzw. R94 und einem Heißleiter-Thermistor NTC1 bzw. NTC2. Bei Temperaturüberlastung werden die Heißleiter-Thermistoren NTC1 bzw. NTC2 leitend und schalten die Transistoren Q8 bzw. Q9 ab; in der Folge erhöht sich die Spannung an der Diode D3 bzw. D4, wodurch der steuerbare Gleichspannungswandler IC25 abgeschaltet wird.

In der Fig. 9 sind die drei weiteren Spannungswandler DCDC1, DCDC2 und DCDC3 der Spannungsversorgungseinheit 4 dargestellt, die die gefilterte 24 V-Versorgungsspannung 13 in jeweils eine potentialfreie 12 V-Halbleiterschalter-Steuerspannung wandeln.

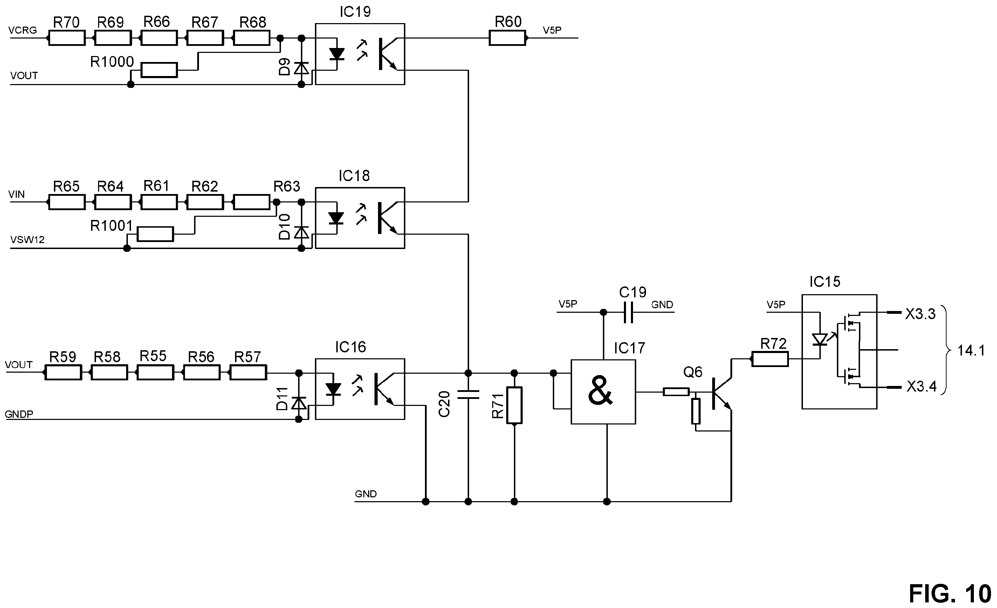

Die Fig. 10 zeigt den ersten Diagnosekanal 3.1 der Diagnoseeinheit 3. Dieser liefert an den Anschlüssen X3.3, X3.4 das erste Rückmeldesignal 14.1. Die Schaltungsanordnung des ersten Diagnosekanals 3.1 umfasst den Optokoppler IC19, an dem eingangsseitig das Ladespannungspotential VCRG und das Ausgangslastpotential VOUT anliegen, den Optokoppler IC18, an dem eingangsseitig das Eingangslastpotential VIN und das Zwischenschalterpotential VSW12 anliegen, und den Optokoppler IC16, an dem eingangsseitig das Ausgangslastpotential VOUT und das lastseitige Massepotential GNDP anliegen. Ausgangsseitig sind die Optokoppler IC19, IC18 und IC 16, wie in Fig. 10, gezeigt miteinander verbunden. Der Widerstand R60 ist ein Vorwiderstand. Der Widerstand R71 wird als Pull-down-Widerstand genutzt, um das Signal bei einem Fehler sicher auf das steuerungsseitige Massepotential GND zu ziehen. Der Kondensator C20 dient zu Signalstabilisierung.

Um das ordnungsgemäße Abschalten über das erste Rückmeldesignal 14.1 zu detektieren, müssen gleichzeitig folgenden Bedingungen erfüllt sein:
a) Es muss eine Spannung über dem Halbleiterschalter (MOSFET) des Ladekreises 1.3 anliegen, d. h. die Spannungsdifferenz zwischen dem Ladespannungspotential VCRG und dem Ausgangslastpotential VOUT muss größer als 14 V sein (der Ausgang am Optokoppler IC19 ist dann aktiv); und
b) es muss eine Spannung über der Halbleiterschaltung des ersten Abschaltkreises 1.1 anliegen, d. h. die Spannungsdifferenz zwischen dem Eingangslastpotential VIN und dem Zwischenschalterpotential VSW12 muss größer als 14 V sein (der Ausgang am Optokoppler IC18 ist dann aktiv); und
c) die Ausgangslastspannung 11 muss gering sein, d. h. die Spannungsdifferenz zwischen dem Ausgangslastpotential VOUT und dem lastseitigen Massepotential GNDP darf 8 V nicht überschreiten (der Ausgang am Optokoppler IC16 ist dann inaktiv).

Wenn alle drei Bedingungen gleichzeitig erfüllt sind, wird über das UND-Gatter IC17 und dem NPN-Transistor Q6 der Optokoppler IC15 angesteuert, über dem dann das erste Rückmeldesignal 14.1 ausgegeben wird. Durch das Rückmeldesignal 14.1 wird mithin signalisiert, dass keine Ausgangslastspannung 11 anliegt und gleichzeitig die Schaltelemente des ersten Abschaltkreises 1.1 und des Ladekreises 1.3 ausgeschaltet sind.

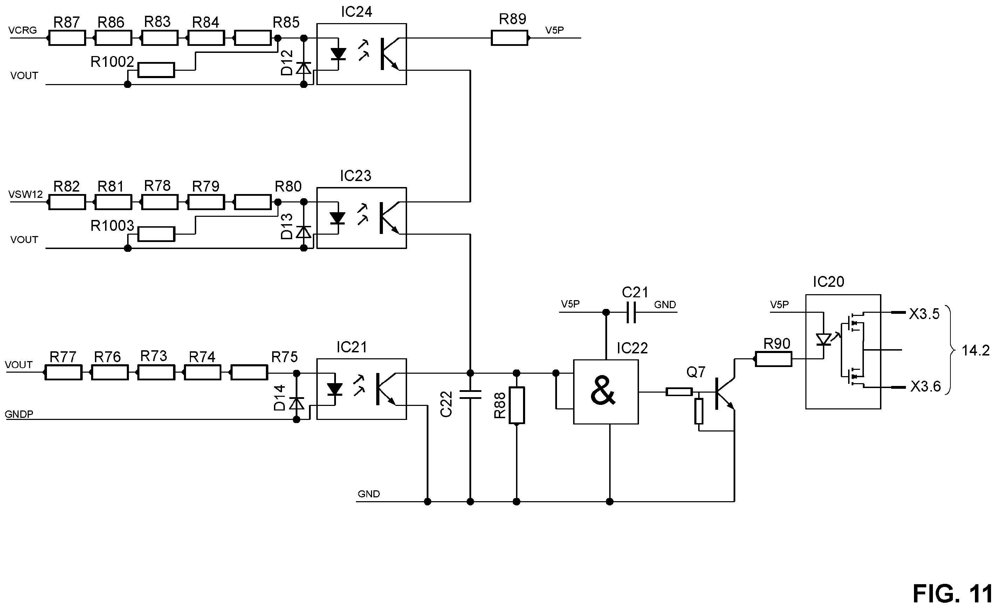

Die Fig. 11 zeigt den vergleichbar zum ersten Diagnosekanal 3.1 aufgebauten zweiten Diagnosekanal 3.2 der Diagnoseeinheit 3. Dieser liefert an den Anschlüssen X3.5, X3.6 das zweite Rückmeldesignal 14.2. Die Schaltungsanordnung des zweiten Diagnosekanals 3.2 umfasst den Optokoppler IC24, an dem eingangsseitig das Ladespannungspotential VCRG und das Ausgangslastpotential VOUT anliegen, den Optokoppler IC23, an dem eingangsseitig das Zwischenschalterpotential VSW12 und das Ausgangslastpotential VOUT anliegen, und den Optokoppler IC21, an dem eingangsseitig das Ausgangslastpotential VOUT und das lastseitige Massepotential GNDP anliegen. Ausgangsseitig sind die Optokoppler IC24, IC23 und IC 21, wie in Fig. 11 gezeigt, miteinander verbunden. Der Widerstand R89 ist ein Vorwiderstand. Der Widerstand R88 wird als Pull-down-Widerstand genutzt, um das Signal bei einem Fehler sicher auf das steuerungsseitige Massepotential GND zu ziehen. Der Kondensator C22 dient zu Signalstabilisierung.

Um das ordnungsgemäße Abschalten über das zweite Rückmeldesignal 14.2 zu detektieren, müssen gleichzeitig folgenden Bedingungen erfüllt sein:
a) Es muss eine Spannung über dem Halbleiterschalter (MOSFET) des Ladekreises 1.3 anliegen, d. h. die Spannungsdifferenz zwischen dem Ladespannungspotential VCRG und dem Ausgangslastpotential VOUT muss größer als 14 V sein (der Ausgang am Optokoppler IC24 ist dann aktiv); und
b) es muss eine Spannung über der Halbleiterschaltung des zweiten Abschaltkreises 1.2 anliegen, d. h. die Spannungsdifferenz zwischen dem Zwischenschalterpotential VSW12 und dem Ausgangslastpotential VOUT muss größer als 14 V sein (der Ausgang am Optokoppler IC23 ist dann aktiv); und
c) die Ausgangslastspannung 11 muss gering sein, d. h. die Spannungsdifferenz zwischen dem Ausgangslastpotential VOUT und dem lastenseitigen Massepotential GNDP darf 8 V nicht überschreiten (der Ausgang am Optokoppler IC21 ist dann inaktiv).

Wenn alle drei Bedingungen gleichzeitig erfüllt sind, wird über das UND-Gatter IC22 und dem NPN-Transistor Q7 der Optokoppler IC20 angesteuert, über dem dann das zweite Rückmeldesignal 14.2 ausgegeben wird. Durch das zweite Rückmeldesignal 14.2 wird mithin signalisiert, dass keine Ausgangslastspannung 11 anliegt und gleichzeitig die Schaltelemente des zweiten Abschaltkreises 1.2 und des Ladekreises 1.3 ausgeschaltet sind.

Die beiden Diagnosekanäle 3.1, 3.2 ermöglichen folglich eine redundante Diagnose der Schaltelemente des Ladekreises 1.3 und gleichzeitig eine gezielte, unabhängige Diagnose der Schaltelemente der beiden Abschaltkreise 1.1, 1.2.

Der zweite Ausführung des Abschaltmoduls gemäß Fig. 12 unterscheidet sich von der ersten Ausführung darin, dass am Ladekreis 1.3 zwei Ladespannungspotentiale VCRG, nämlich das erste Ladespannungspotential VCRG1 und das zweite Ladespannungspotential VCRG2, abgegriffen werden. Das ersten Ladespannungspotential VCRG1 ist ein Eingangssignal für den ersten Diagnosekanal 3.1 und das zweite Ladespannungspotential VCRG2 ist ein Eingangssignal für den ersten Diagnosekanal 3.1 und für den zweiten Diagnosekanal 3.2.

Die Spannungsversorgungseinheit 4 der zweiten Ausführung des Abschaltmoduls weist im Unterschied zur ersten Ausführung ferner neben dem ersten Spannungswandler zur Erzeugung der 5 V-Steuerspannung vier (statt drei) weitere Spannungswandler zur Erzeugung der 12 V-Halbleiterschalter-Steuerspannungen auf. Diese Halbleiterschalter-Steuerspannungen sind durch das erste Halbleiterschalter-Steuerpotential V12P-S1, das zweite Halbleiterschalter-Steuerpotential V12P-OUT1, das dritte Halbleiterschalter-Steuerpotential V12P-D und das vierte Halbleiterschalter-Steuerpotential V12P-OUT2 gekennzeichnet.

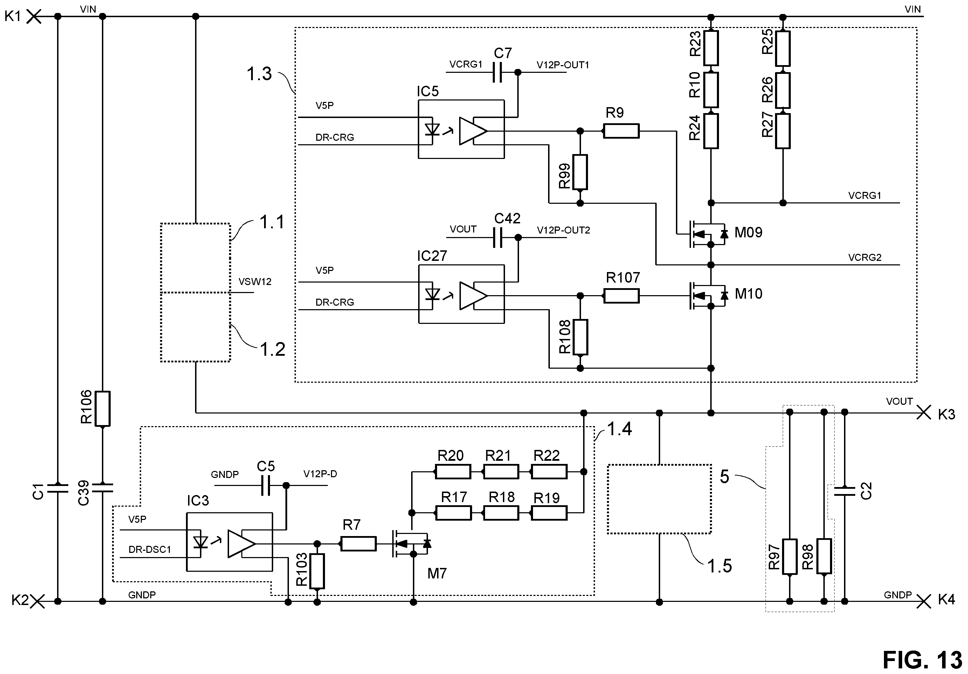

Gemäß Fig. 13 besitzt der Ladekreis 1.3 zwei Halbleiterschalter, nämlich den ersten Ladekreis-Halbleiterschalter (MOSFET M9) und den zweiten Ladekreis-Halbleiterschalter (MOSFET M10). Deren Ansteuerung erfolgt über die mit IC5 bzw. IC27 gekennzeichneten Optokoppler. Die Widerstände R9 bzw. R107 bilden Gate-Vorwiderstände und die Widerstände R99 bzw. R108 Abschaltwiderstände bei Spannungsausfall. Als Eingangssignal zur Steuerung beider Ladekreis-Optokoppler IC5, IC27 dient das Ladeansteuerungspotential DR-CRG. Neben den MOSFETs M9, M10 weist der Ladekreis 1.3 die Widerstandskaskade aus den Leistungswiderständen R10, R23, R24, R25, R26 und R27 auf, wobei der zweite Ladekreis-Halbleiterschalter (MOSFET M10), der erste Ladekreis-Halbleiterschalter (MOSFET M9) und diese Widerstandskaskade die Nebenverbindung zwischen dem Eingangslastpotential VIN und dem Ausgangslastpotential VOUT bilden. Zwischen dem ersten Ladekreis-Halbleiterschalter (MOSFET M9) und der Leistungswiderstandskaskade wird das erste Ladespannungspotential VCRG1 und zwischen dem zweiten Ladekreis-Halbleiterschalter (MOSFET M10) und dem ersten Ladekreis-Halbleiterschalter (MOSFET M9) das zweite Ladespannungspotential VCRG2 abgegriffen.

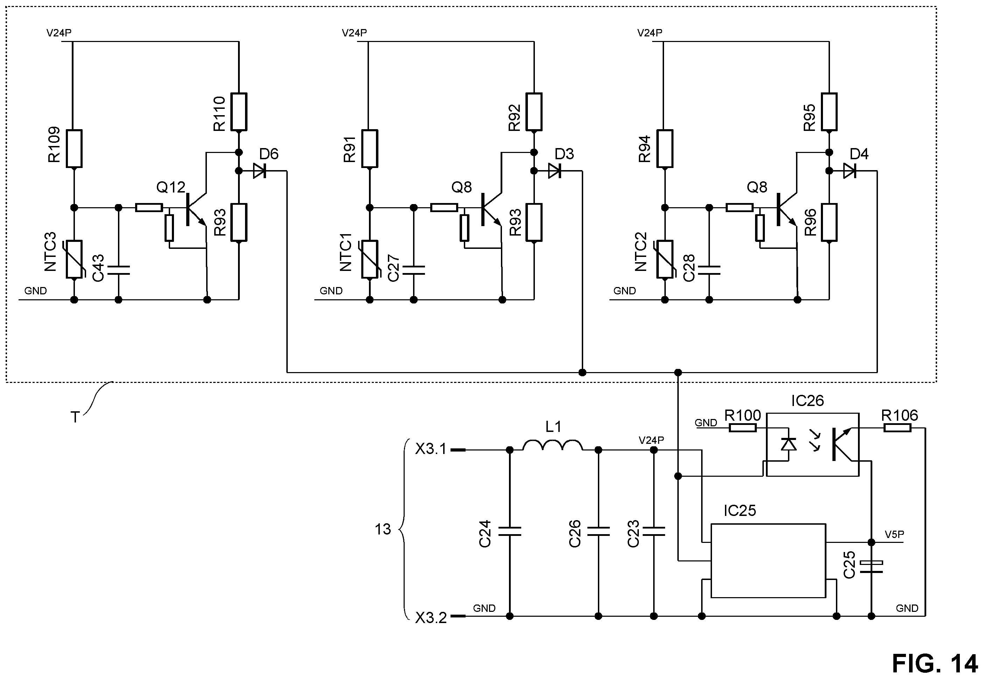

Die Fig. 14 zeigt die Spannungsversorgungseinheit 4 gemäß der zweiten Ausführung des Abschaltmoduls mit dem ersten Spannungswandler IC25 zur Erzeugung der 5 V-Steuerspannung und dem Temperaturüberwachungskreis T, der drei parallel geschaltete Schaltkreise zur Temperaturabschaltung besitzt. Jeder der Schaltkreise zur Temperaturabschaltung besitzt einen Spannungsteiler aus einem Vorwiderstand R91, R94 bzw. R109 und einem Heißleiter-Thermistor NTC1, NTC2 bzw. NTC3. Bei Temperaturüberlastung werden die Heißleiter-Thermistoren NTC1, NTC2 bzw. NTC3 leitend und schalten die Transistoren Q8, Q9 bzw. Q12 ab; in der Folge erhöht sich die Spannung an der Diode D3, D4 bzw. D6, wodurch der steuerbare Gleichspannungswandler IC25 abgeschaltet wird. Die Abschalttemperatur ist auf 80 °C eingestellt.

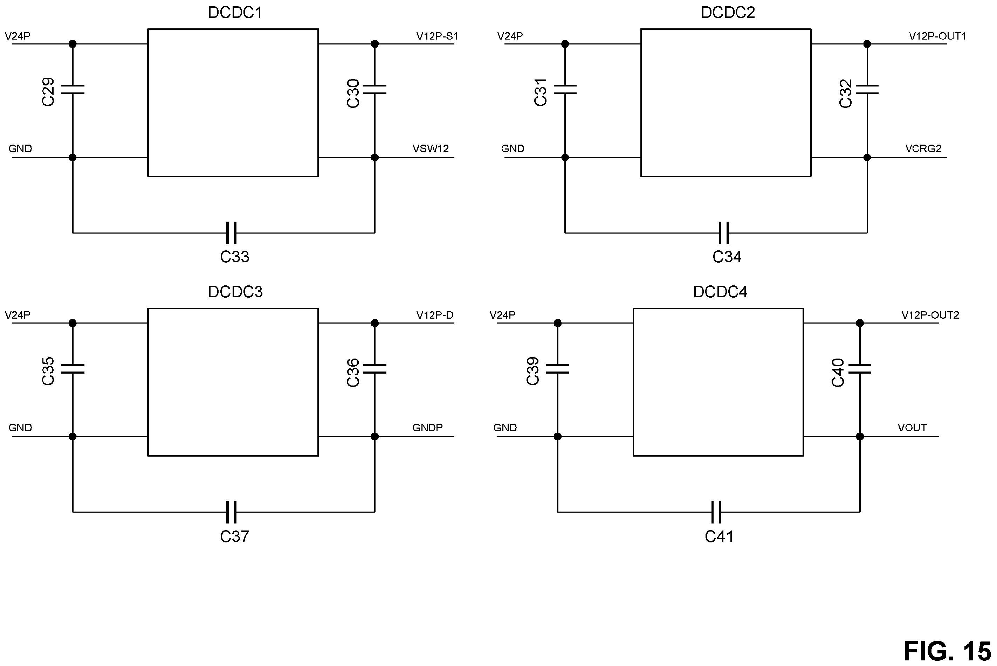

In der Fig. 15 sind die vier weiteren Spannungswandler DCDC1, DCDC2, DCDC3 und DCDC4 der Spannungsversorgungseinheit 4 gemäß der zweiten Ausführung des Abschaltmoduls dargestellt, die die gefilterte 24 V-Versorgungsspannung 13 in jeweils eine potentialfreie 12 V-Halbleiterschalter-Steuerspannung wandeln.

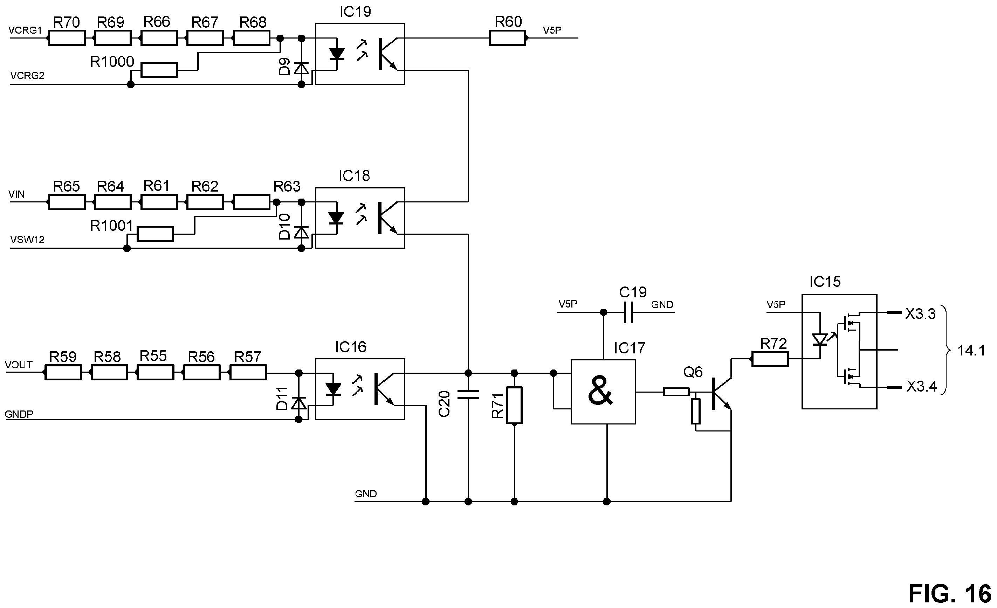

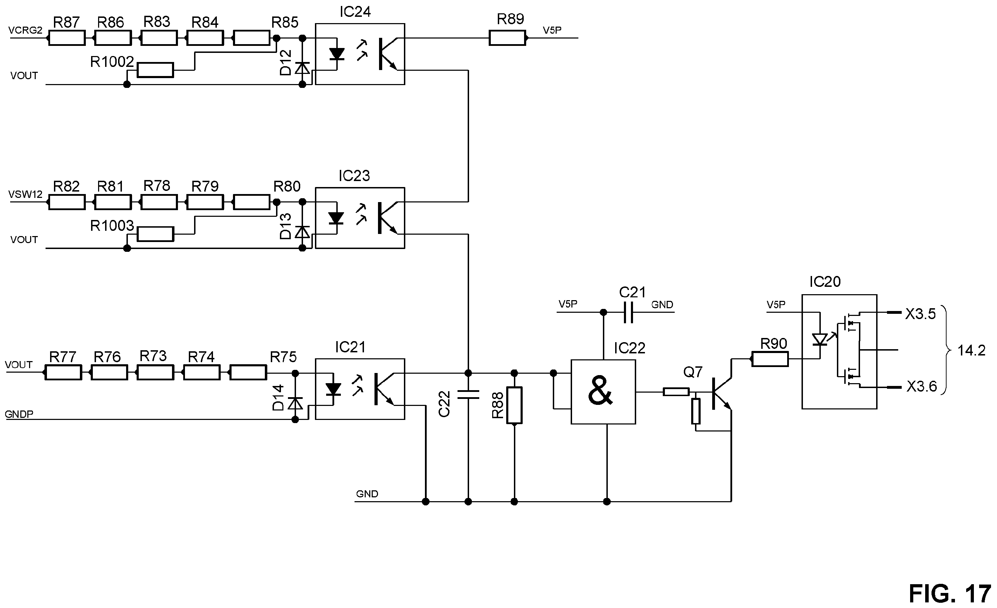

Die in den Fig. 16 und 17 dargestellten Diagnosekanäle 3.1, 3.2 entsprechen weitgehend denen nach Fig. 10 und 11 mit dem Unterschied der Verarbeitung des Ladespannungspotentials VCRG, das gemäß der zweiten Ausführung des Abschaltmoduls in Form des ersten Ladespannungspotentials VCRG1 und des zweiten Ladespannungspotentials VCRG2 am Ladekreis 1.3 abgegriffen wird.

Gemäß Fig. 16 liegen am Optokoppler IC19 eingangsseitig statt des Ladespannungspotentials VCRG und des Ausgangslastpotentials VOUT das erste Ladespannungspotentials VCRG1 und das zweite Ladespannungspotentials VCRG2 an.

Um das ordnungsgemäße Abschalten über das erste Rückmeldesignal 14.1 des Diagnosekanals 3.1zu detektieren, müssen gleichzeitig folgenden Bedingungen erfüllt sein:
a) Es muss eine Spannung über dem ersten Ladekreis-Halbleiterschalter (MOSFET M9) des Ladekreises 1.3 anliegen, d. h. die Spannungsdifferenz zwischen dem ersten Ladespannungspotential VCRG1 und dem zweiten Ladespannungspotential VCRG2 muss größer als 14 V sein (der Ausgang am Optokoppler IC19 ist dann aktiv); und
b) es muss eine Spannung über der Halbleiterschaltung des ersten Abschaltkreises 1.1 anliegen, d. h. die Spannungsdifferenz zwischen dem Eingangslastpotential VIN und dem Zwischenschalterpotential VSW12 muss größer als 14 V sein (der Ausgang am Optokoppler IC18 ist dann aktiv); und
c) die Ausgangslastspannung 11 muss gering sein, d. h. die Spannungsdifferenz zwischen dem Ausgangslastpotential VOUT und dem lastseitigen Massepotential GNDP darf 8 V nicht überschreiten (der Ausgang am Optokoppler IC16 ist dann inaktiv).

Gemäß der zweiten Ausführung des Abschaltmoduls liegt gemäß Fig. 17 am Optokoppler IC24 eingangsseitig statt des Ladespannungspotentials VCRG das zweite Ladespannungspotential VCRG2 an.

Um das ordnungsgemäße Abschalten über das zweite Rückmeldesignal 14.2 des Diagnosekanals 3.2 zu detektieren, müssen gleichzeitig folgenden Bedingungen erfüllt sein:
a) Es muss eine Spannung über dem zweiten Ladekreis-Halbleiterschalter (MOSFET M10) des Ladekreises 1.3 anliegen, d. h. die Spannungsdifferenz zwischen dem zweiten Ladespannungspotential VCRG2 und dem Ausgangslastpotential VOUT muss größer als 14 V sein (der Ausgang am Optokoppler IC24 ist dann aktiv); und
b) es muss eine Spannung über der Halbleiterschaltung des zweiten Abschaltkreises 1.2 anliegen, d. h. die Spannungsdifferenz zwischen dem Zwischenschalterpotential VSW12 und dem Ausgangslastpotential VOUT muss größer als 14 V sein (der Ausgang am Optokoppler IC23 ist dann aktiv); und
c) die Ausgangslastspannung 11 muss gering sein, d. h. die Spannungsdifferenz zwischen dem Ausgangslastpotential VOUT und dem lastenseitigen Massepotential GNDP darf 8 V nicht überschreiten (der Ausgang am Optokoppler IC21 ist dann inaktiv).

Die beiden Diagnosekanäle 3.1, 3.2 gemäß der zweiten Ausführung des Abschaltmoduls ermöglichen eine gezielte, unabhängige Diagnose der Schaltelemente der beiden Abschaltkreise 1.1, 1.2 sowie des Ladekreises 1.3.

### Bezugszeichenliste

- 1: Abschalteinheit
- 1.1: erster Abschaltkreis
- 1.2: zweiter Abschaltkreis
- 1.3: Ladekreis
- 1.4: erste Entladekreis
- 1.5: zweite Entladekreis
- 2: Ansteuerungseinheit
- 2.1: erste Abschaltansteuerung
- 2.2: zweite Abschaltansteuerung
- 2.3: Ladekreisansteuerung
- 2.4: erste Entladekreisansteuerung
- 2.5: zweite Entladekreisansteuerung
- 2.6: Ansteuerungseingangskreis
- 3: Diagnoseeinheit
- 3.1: erster Diagnosekanal
- 3.2: zweiter Diagnosekanal
- 4: Spannungsversorgungseinheit
- 5: Ausfallschutzkreis
- 6: Überlastungsschutzkreis
- 10: Eingangslastspannung
- 11: Ausgangslastspannung
- 12: Schaltsignal
- 12.1: erstes Schaltsignal
- 12.2: zweites Schaltsignal
- 13: Versorgungsspannung
- 14: Rückmeldesignal
- 14.1: erstes Rückmeldesignal
- 14.2: zweites Rückmeldesignal
- VIN: Eingangslastpotential
- VOUT: Ausgangslastpotential
- VCRG: Ladespannungspotential
- VCRG1: erstes Ladespannungspotential
- VCRG2: zweites Ladespannungspotential
- VSW12: Zwischenschalterpotential
- V24P: Versorgungsspannungspotential
- V5P: Steuerspannungspotential
- V12P-S1: erstes Halbleiterschalter-Steuerpotential
- V12P-OUT: zweites Halbleiterschalter-Steuerpotential (erste Ausführung)
- V12P-OUT1: zweites Halbleiterschalter-Steuerpotential (zweite Ausführung)
- V12P-D: drittes Halbleiterschalter-Steuerpotential
- V12P-OUT2: viertes Halbleiterschalter-Steuerpotential
- GNDP: lastseitiges Massepotential
- GND: steuerungsseitiges Massepotential
- INT1: erstes Schaltsignalpotential
- INT2: zweites Schaltsignalpotential
- DR-SW1: erstes Schaltsteuerungspotential
- DR-SW2: zweites Schaltsteuerungspotential
- DR-CRG: Ladeansteuerungspotential
- DR-DSC1: erstes Entladeansteuerungspotential
- DR-DSC2: zweites Entladeansteuerungspotential
- C: Kondensator
- D: Diode
- DCDC: Spannungswandler (Gleichstrom-)
- IC: integrierter Schaltkreis
- K: Anschlussklemme (Lastspannung)
- L: Spule
- M: Metall-Oxid-Halbleiter-Feldeffekttransistor (MOSFET)
- NTC: Heißleiter-Thermistor
- Q: Transistor
- R: Widerstand
- T: Temperaturüberwachungskreis
- X: Anschluss

## Patentansprüche

1. Abschaltmodul zur sicheren Abschaltung einer Gleichspannungslast, die in Form einer Lastspannung als eingehende Eingangslastspannung (10) zwischen einem Eingangslastpotential (VIN) und einem lastseitigen Massepotential (GNDP) und als abgehende Ausgangslastspannung (11) zwischen einem
Ausgangslastpotential (VOUT) und dem lastseitigen Massepotential (GNDP) an einem Lastkreis des Abschaltmoduls anliegt, wobei das Abschaltmodul eingerichtet ist, bei Unterbrechung mindestens eines am Abschaltmodul eingehenden Schaltsignals (12) den Lastkreis mittels einer halbleiterbasierten Abschalteinheit (1) durch Unterbrechung der Verbindung von Eingangslastpotential (VIN) und Ausgangslastpotential (VOUT) abzuschalten sowie mindestens ein die Lastabschaltung kenntlich machendes Rückmeldesignal (14) auszugeben,
wobei das Abschaltmodul aufweist:
- die halbleiterbasierte Abschalteinheit (1) mit einem ersten Abschaltkreis (1.1), einem zweiten Abschaltkreis (1.2) und einem Ladekreis (1.3);
- eine Ansteuerungseinheit (2) mit einem ein eingehendes erstes (12.1) und ein eingehendes zweites (12.2) Schaltsignal (12) verarbeitenden Ansteuerungseingangskreis (2.6), einer ersten Abschaltsteuerung (2.1) zur Ansteuerung des ersten Abschaltkreises (1.1), einer zweiten Abschaltsteuerung (2.2) zur Ansteuerung des zweiten Abschaltkreises (1.2) und einer Ladekreisansteuerung (2.3) zur Ansteuerung des Ladekreises (1.3);
- eine Diagnoseeinheit (3) mit einem ersten Diagnosekanal (3.1) zur Ausgabe eines ersten Rückmeldesignals (14.1) und einem zweiten Diagnosekanal (3.2) zur Ausgabe eines zweiten Rückmeldesignals (14.2); und
- eine an eine Versorgungsspannung (13) angeschlossene Spannungsversorgungseinheit (4) zur Spannungsversorgung der Einheiten des Abschaltmoduls;
wobei
- die Verbindung zwischen dem Eingangslastpotential (VIN) und dem Ausgangslastpotential (VOUT) eine über die beiden Abschaltkreise (1.1, 1.2) geschaltete Hauptverbindung und eine parallel über den Ladekreis (1.3) geschaltete Nebenverbindung umfasst, und
- der erste Abschaltkreis (1.1) und der zweite Abschaltkreis (1.2) jeweils eine Halbleiterschaltung mit mindestens einem Halbleiterschalter aufweist, wobei die Hauptverbindung zwischen dem Eingangslastpotential (VIN) und dem Ausgangslastpotential (VOUT) durch die in Reihe geschalteten Halbleiterschaltungen des ersten Abschaltkreises (1.1) und des zweiten Abschaltkreises (1.2) gebildet ist, und wobei der oder die Halbleiterschalter der jeweiligen Halbleiterschaltung zur Steuerung der Aktivierung oder Sperrung der Hauptverbindung über jeweils einen Optokoppler an die jeweils zugeordnete Abschaltsteuerung (2.1, 2.2) angeschlossenen sind, und
- die erste Abschaltsteuerung (2.1) und die zweite Abschaltsteuerung (2.2) eingerichtet sind, die Hauptverbindung zu aktivieren, wenn beide an der Ansteuerungseinheit (2) eingehenden Schaltsignale (12.1, 12.2) anliegen und die Spannungsdifferenz zwischen Eingangslastpotential (VIN) und Ausgangslastpotential (VOUT) einen vorgegebenen Schwellwert unterschreitet, und
- der Ladekreis (1.3) mindestens einen Halbleiterschalter und mindestens einen Leistungswiderstand umfasst, die in Reihe geschaltet die Nebenverbindung zwischen dem Eingangslastpotential (VIN) und dem Ausgangslastpotential (VOUT) bilden, wobei der Halbleiterschalter des Ladekreises (1.3) zur Steuerung der Aktivierung oder Sperrung der Nebenverbindung über einen Optokoppler an die Ladekreisansteuerung (2.3) angeschlossen ist, und
- die Ladekreisansteuerung (2.3) eingerichtet ist, die Nebenverbindung durch Ansteuerung des Optokopplers des Ladekreises (1.3) zu aktivieren, wenn beide an der Ansteuerungseinheit (2) eingehenden Schaltsignale (12.1, 12.2) anliegen, und
- in der Hauptverbindung zwischen dem Halbleiterschalter des ersten Abschaltkreises (1.1) und des zweiten Abschaltkreises (1.2) ein Zwischenschalterpotential (VSW12) anliegt, und
- in der Nebenverbindung zwischen dem mindestens einen Halbleiterschalter und dem oder den Leistungswiderständen des Ladekreises (1.3) ein Ladespannungspotential (VCRG) anliegt, und
- der erste Diagnosekanal (3.1) eingerichtet ist, über das erste Rückmeldesignal (14.1) eine ordnungsgemäße Abschaltung des Lastkreises zu signalisieren, wenn die Spannungsdifferenz zwischen dem Ladespannungspotential (VCRG) und dem Ausgangslastpotential (VOUT) einen vorgegebenen Schwellwert überschreitet und die Spannungsdifferenz zwischen dem Eingangslastpotential (VIN) und dem Zwischenschalterpotential (VSW12) einen vorgegebenen Schwellwert überschreitet und die Spannungsdifferenz zwischen dem Ausgangslastpotential (VOUT) und dem lastseitigen Massepotential (GNDP) einen vorgegebenen Schwellwert unterschreitet, und
- der zweite Diagnosekanal (3.2) eingerichtet ist, über das zweite Rückmeldesignal (14.2) eine ordnungsgemäße Abschaltung des Lastkreises zu signalisieren, wenn die Spannungsdifferenz zwischen dem Ladespannungspotential (VCRG) und dem Ausgangslastpotential (VOUT) einen vorgegebenen Schwellwert überschreitet und die Spannungsdifferenz zwischen dem Zwischenschalterpotential (VSW12) und dem Ausgangslastpotential (VOUT) einen vorgegebenen Schwellwert überschreitet und die Spannungsdifferenz zwischen dem Ausgangslastpotential (VOUT) und dem lastseitigen Massepotential (GNDP) einen vorgegebenen Schwellwert unterschreitet.

2. Abschaltmodul nach Anspruch 1, **dadurch gekennzeichnet, dass** die Abschalteinheit (1) ferner einen ersten Entladekreis (1.4) sowie einen zweiten Entladekreis (1.5) und die Ansteuerungseinheit (2) ferner eine erste Entladekreisansteuerung (2.4) zur Ansteuerung des ersten Entladekreises (1.4) sowie eine zweite Entladekreisansteuerung (2.5) zur Ansteuerung des zweiten Entladekreises (2.4) aufweist,
- wobei der erste Entladekreis (1.4) mindestens einen Halbleiterschalter und mindestens einen Leistungswiderstand umfasst, die in Reihe geschaltet eine erste Entladeverbindung zwischen dem Ausgangslastpotential (VOUT) und dem lastseitigen Massepotential (GNDP) bilden, wobei der Halbleiterschalter des ersten Entladekreises (1.4) zur Steuerung der Aktivierung oder Sperrung der ersten Entladeverbindung über einen Optokoppler an die erste Entladekreisansteuerung (2.4) angeschlossen ist, und wobei die erste Entladekreisansteuerung (2.4) eingerichtet ist, die erste Entladeverbindung durch Ansteuerung des Optokopplers des ersten Entladekreises (1.4) zu aktivieren, wenn das an der Ansteuerungseinheit (1) eingehende erste Schaltsignal (12.1) unterbrochen ist, und
- wobei der zweite Entladekreis (1.5) mindestens einen Halbleiterschalter und mindestens einen Leistungswiderstand umfasst, die in Reihe geschaltet eine zweite, parallel zur ersten Entladeverbindung geschaltete Entladeverbindung zwischen dem Ausgangslastpotential (VOUT) und dem lastseitigen Massepotential (GNDP) bilden, wobei der Halbleiterschalter des zweiten Entladekreises (1.5) zur Steuerung der Aktivierung oder Sperrung der zweiten Entladeverbindung über einen Optokoppler an die zweite Entladekreisansteuerung (2.5) angeschlossen ist, und wobei die zweite Entladekreisansteuerung (2.5) eingerichtet ist, die zweite Entladeverbindung durch Ansteuerung des Optokopplers des zweiten Entladekreises (1.5) zu aktivieren, wenn das an der Ansteuerungseinheit (2) eingehende zweite Schaltsignal (12.2) unterbrochen ist.

3. Abschaltmodul nach Anspruch 2, **dadurch gekennzeichnet, dass** die Größe der Leistungswiderstände im ersten Entladekreis (1.4) und im zweiten Entladekreis (1.5) so bemessen sind, dass die aktivierten Entladeverbindungen die Ausgangslastspannung (11) auf ein Drittel der Eingangslastspannung (10) reduzieren.

4. Abschaltmodul nach einem der Ansprüche 1 bis 3, **dadurch gekennzeichnet, dass** jede der Halbleiterschaltungen des ersten Abschaltkreises (1.1) und des zweiten Abschaltkreises (1.2) jeweils drei parallel geschaltete Halbleiterschalter aufweist.

5. Abschaltmodul nach einem der Ansprüche 1 bis 4, **dadurch gekennzeichnet, dass** die Abschalteinheit (1) ferner einen Ausfallschutzkreis (5) mit einer Ausfallentladeverbindung zwischen dem Ausgangslastpotential (VOUT) und dem lastseitigen Massepotential (GNDP) aufweist, wobei die Ausfallentladeverbindung mindestens einen Leistungswiderstand oder zwei parallel geschaltete Leistungswiderstände aufweist.

6. Abschaltmodul nach einem der Ansprüche 1 bis 5, **dadurch gekennzeichnet, dass** die Ansteuerungseinheit (2) ferner einen an die zweite Abschaltansteuerung (2.2) angeschlossenen Überlastschutzkreis (6) aufweist, der eingerichtet, die zweite Abschaltansteuerung (2.2) zu deaktivieren, wenn die Versorgungsspannung (13) der Spannungsversorgungseinheit (4) unter einen vorgegebenen Schwellwert fällt.

7. Abschaltmodul nach einem der Ansprüche 1 bis 6, **dadurch gekennzeichnet, dass** die Spannungsversorgungseinheit (4) einen ersten Spannungswandler (IC25) zur Wandlung der Versorgungsspannung (13) in eine Steuerspannung zur Spannungsversorgung der Ansteuerungseinheit (2) und der Diagnoseeinheit (3) sowie weitere Spannungswandler (DCDC1, DCDC2, DCDC3, DCDC4) zur Wandlung der Versorgungsspannung (13) in potentialfreie Halbleiterschalter-Steuerungsspannungen umfasst.

8. Abschaltmodul nach Anspruch 7, **dadurch gekennzeichnet, dass** in die Spannungsversorgungseinheit (4) ein Temperaturüberwachungskreis (T) integriert ist, wobei der erste Spannungswandler (IC25) einen Steuereingang aufweist, an dem der Temperaturüberwachungskreis (T) angeschlossen ist.

9. Abschaltmodul nach Anspruch 8, **dadurch gekennzeichnet, dass** der Temperaturüberwachungskreis (T) aus zwei oder drei parallel geschalteten Schaltkreisen besteht, die zur Temperaturerfassung jeweils einen Heißleiter-Thermistor (NTC1, NTC2, NTC3) aufweisen.

10. Abschaltmodul nach einem der Ansprüche 1 bis 9, **dadurch gekennzeichnet, dass** die vorgegebenen Schwellwerte der Spannungsdifferenzen jeweils auf einen Wert von 4 V ± 1 V, 8 V ± 1 V oder 14 V ± 1 V eingestellt sind.

## Claims

1. Disconnection module for safely disconnecting a DC voltage load, which is applied in the form of a load voltage as an incoming input load voltage (10) between an input load potential (VIN) and a load-side ground potential (GNDP), and as an outgoing output load voltage (11) between an output load potential (VOUT) and the load-side ground potential (GNDP) at a load circuit of the disconnection module, wherein the disconnection module is configured, upon interruption of at least one switching signal (12) incoming to the disconnection module, to disconnect the load circuit by means of a semiconductor-based disconnection unit (1) by interrupting the connection between the input load potential (VIN) and the output load potential (VOUT), and to output at least one feedback signal (14) indicating the load disconnection,
wherein the disconnection module comprises:
- the semiconductor-based disconnection unit (1) with a first disconnection circuit (1.1), a second disconnection circuit (1.2), and a charging circuit (1.3);
- a control unit (2) with a control input circuit (2.6) processing an incoming first (12.1) and an incoming second (12.2) switching signal (12), a first disconnection control (2.1) for controlling the first disconnection circuit (1.1), a second disconnection control (2.2) for controlling the second disconnection circuit (1.2), and a charging-circuit control (2.3) for controlling the charging circuit (1.3);
- a diagnostic unit (3) with a first diagnostic channel (3.1) for outputting a first feedback signal (14.1) and a second diagnostic channel (3.2) for outputting a second feedback signal (14.2); and
- a power supply unit (4), connected to a supply voltage (13), for supplying power to the units of the disconnection module;
wherein
- the connection between the input load potential (VIN) and the output load potential (VOUT) comprises a main connection connected via the two disconnection circuits (1.1, 1.2) and a secondary connection connected in parallel via the charging circuit (1.3), and
- the first disconnection circuit (1.1) and the second disconnection circuit (1.2) each comprise a semiconductor circuit with at least one semiconductor switch, wherein the main connection between the input load potential (VIN) and the output load potential (VOUT) is formed by the semiconductor circuits of the first disconnection circuit (1.1) and the second disconnection circuit (1.2) connected in series, and wherein the semiconductor switch or switches of the respective semiconductor circuit are connected to the respectively assigned disconnection control (2.1, 2.2) via an optocoupler for controlling the activation or blocking of the main connection, and
- the first disconnection control (2.1) and the second disconnection control (2.2) are configured to activate the main connection when both switching signals (12.1, 12.2) incoming to the control unit (2) are present and the voltage difference between the input load potential (VIN) and the output load potential (VOUT) falls below a predetermined threshold value, and
- the charging circuit (1.3) comprises at least one semiconductor switch and at least one power resistor which, connected in series, form the secondary connection between the input load potential (VIN) and the output load potential (VOUT), wherein the semiconductor switch of the charging circuit (1.3) is connected to the charging-circuit control (2.3) via an optocoupler for controlling the activation or blocking of the secondary connection, and
- the charging-circuit control (2.3) is configured to activate the secondary connection by controlling the optocoupler of the charging circuit (1.3) when both switching signals (12.1, 12.2) incoming to the control unit (2) are present, and
- an intermediate-switch potential (VSW12) is present in the main connection between the semiconductor switch of the first disconnection circuit (1.1) and that of the second disconnection circuit (1.2), and
- a charging-voltage potential (VCRG) is present in the secondary connection between the at least one semiconductor switch and the power resistor(s) of the charging circuit (1.3), and
- the first diagnostic channel (3.1) is configured to signal, via the first feedback signal (14.1), a proper disconnection of the load circuit when the voltage difference between the charging-voltage potential (VCRG) and the output load potential (VOUT) exceeds a predetermined threshold value, and the voltage difference between the input load potential (VIN) and the intermediate-switch potential (VSW12) exceeds a predetermined threshold value, and the voltage difference between the output load potential (VOUT) and the load-side ground potential (GNDP) falls below a predetermined threshold value, and
- the second diagnostic channel (3.2) is configured to signal, via the second feedback signal (14.2), a proper disconnection of the load circuit when the voltage difference between the charging-voltage potential (VCRG) and the output load potential (VOUT) exceeds a predetermined threshold value, and the voltage difference between the intermediate-switch potential (VSW12) and the output load potential (VOUT) exceeds a predetermined threshold value, and the voltage difference between the output load potential (VOUT) and the load-side ground potential (GNDP) falls below a predetermined threshold value.

2. Disconnection module according to claim 1, **characterized in that** the disconnection unit (1) further comprises a first discharge circuit (1.4) as well as a second discharge circuit (1.5), and the control unit (2) further comprises a first discharge-circuit control (2.4) for controlling the first discharge circuit (1.4) as well as a second discharge-circuit control (2.5) for controlling the second discharge circuit (1.5),
- wherein the first discharge circuit (1.4) comprises at least one semiconductor switch and at least one power resistor, which, connected in series, form a first discharge connection between the output load potential (VOUT) and the load-side ground potential (GNDP), wherein the semiconductor switch of the first discharge circuit (1.4) is connected to the first discharge-circuit control (2.4) via an optocoupler for controlling the activation or blocking of the first discharge connection, and wherein the first discharge-circuit control (2.4) is configured to activate the first discharge connection by controlling the optocoupler of the first discharge circuit (1.4) when the first switching signal (12.1) incoming to the control unit (2) is interrupted, and
- wherein the second discharge circuit (1.5) comprises at least one semiconductor switch and at least one power resistor, which, connected in series, form a second discharge connection connected in parallel to the first discharge connection between the output load potential (VOUT) and the load-side ground potential (GNDP), wherein the semiconductor switch of the second discharge circuit (1.5) is connected to the second discharge-circuit control (2.5) via an optocoupler for controlling the activation or blocking of the second discharge connection, and wherein the second discharge-circuit control (2.5) is configured to activate the second discharge connection by controlling the optocoupler of the second discharge circuit (1.5) when the second switching signal (12.2) incoming to the control unit (2) is interrupted.

3. Disconnection module according to claim 2, **characterized in that** the size of the power resistors in the first discharge circuit (1.4) and in the second discharge circuit (1.5) is dimensioned such that the activated discharge connections reduce the output load voltage (11) to one third of the input load voltage (10).

4. Disconnection module according to one of claims 1 to 3, **characterized in that** each of the semiconductor circuits of the first disconnection circuit (1.1) and of the second disconnection circuit (1.2) comprises three semiconductor switches connected in parallel.

5. Disconnection module according to one of claims 1 to 4, **characterized in that** the disconnection unit (1) further comprises a failure-protection circuit (5) with a failure-discharge connection between the output load potential (VOUT) and the load-side ground potential (GNDP), wherein the failure-discharge connection comprises at least one power resistor or two power resistors connected in parallel.

6. Disconnection module according to one of claims 1 to 5, **characterized in that** the control unit (2) further comprises an overload-protection circuit (6) connected to the second disconnection control (2.2), which is configured to deactivate the second disconnection control (2.2) when the supply voltage (13) of the power supply unit (4) falls below a predetermined threshold value.

7. Disconnection module according to one of claims 1 to 6, **characterized in that** the power supply unit (4) comprises a first voltage converter (IC25) for converting the supply voltage (13) into a control voltage for supplying the control unit (2) and the diagnostic unit (3), as well as further voltage
converters (DCDC1, DCDC2, DCDC3, DCDC4) for converting the supply voltage (13) into potential-free semiconductor-switch control voltages.

8. Disconnection module according to claim 7, **characterized in that** a temperature-monitoring circuit (T) is integrated into the power supply unit (4), wherein the first voltage converter (IC25) comprises a control input to which the temperature-monitoring circuit (T) is connected.

9. Disconnection module according to claim 8, **characterized in that** the temperature-monitoring circuit (T) consists of two or three parallel-connected circuits, each comprising a negative temperature coefficient thermistor (NTC1, NTC2, NTC3) for temperature detection.

10. Disconnection module according to one of claims 1 to 9, **characterized in that** the predetermined threshold values of the voltage differences are each set to a value of 4 V ± 1 V, 8 V ± 1 V or 14 V ± 1 V.

## Revendications

1. Module de déconnexion pour déconnexion sécurisée d'une charge de tension CC qui, sous la forme d'une tension de charge, agit comme une tension de charge d'entrée entrante (10) entre un potentiel de charge d'entrée (VIN) et un potentiel de masse côté charge (GNDP) et comme une tension de charge de sortie sortante (11) entre un potentiel de charge de sortie (VOUT) et le potentiel de masse côté charge (GNDP) sur un circuit de charge du module de déconnexion, ledit module de déconnexion étant conçu pour déconnecter le circuit de charge au moyen d'une unité de déconnexion à semi-conducteur (1) en interrompant la connexion du potentiel de charge d'entrée (VIN) et le potentiel de charge de sortie (VOUT) lorsqu'au moins un signal de commutation (12) entrant dans le module de déconnexion est interrompu, et pour émettre au moins un signal de rétroaction (14) identifiant la déconnexion de charge,
ledit module de déconnexion comportant :
- l'unité de déconnexion à semi-conducteur (1) dotée d'un premier circuit de déconnexion (1.1), d'un second circuit de déconnexion (1.2) et d'un circuit de charge (1.3) ;
- une unité de commande (2) dotée d'un circuit d'entrée de commande (2.6) qui traite des premier (12.1) et second (12.2) signaux de commutation entrants (12), un premier dispositif de commande de déconnexion (2.1) pour commander le premier circuit de déconnexion (1.1), un second dispositif de commande de déconnexion (2.2) pour commander le second circuit de déconnexion (1.2) et un dispositif de commande de circuit de charge (2.3) pour commander le circuit de charge (1.3) ;
- une unité de diagnostic (3) dotée d'un premier canal de diagnostic (3.1) pour émettre un premier signal de rétroaction (14.1) et un second canal de diagnostic (3.2) pour émettre un second signal de rétroaction (14.2) ; et
- une unité d'alimentation en tension (4) connectée à une tension d'alimentation (13) pour alimenter en tension les unités du module de déconnexion ;
- ladite connexion entre le potentiel de charge d'entrée (VIN) et le potentiel de charge de sortie (VOUT) comprenant une connexion principale connectée via les deux circuits de déconnexion (1.1, 1.2) et une connexion secondaire connectée en parallèle par l'intermédiaire du circuit de charge (1.3), et
- ledit premier circuit de déconnexion (1.1) et ledit second circuit de déconnexion (1.2) comportant chacun un circuit à semi-conducteur avec au moins un commutateur à semi-conducteur, ladite connexion principale entre le potentiel de charge d'entrée (VIN) et le potentiel de charge de sortie (VOUT) étant formée par les circuits à semi-conducteur connectés en série du premier circuit de déconnexion (1.1) et du second circuit de déconnexion (1.2), et ledit ou lesdits commutateurs à semi-conducteur du circuit à semi-conducteur respectif étant connecté au dispositif de commande de déconnexion respectivement associé (2.1, 2.2) pour commander l'activation ou le verrouillage de la principale connexion par l'intermédiaire d'un optocoupleur respectif, et
- ledit premier dispositif de commande de déconnexion (2.1) et ledit second dispositif de commande de déconnexion (2.2) étant conçus pour activer la principale connexion lorsque les deux signaux de commutations (12.1, 12.2) entrant dans l'unité de commande (2) sont présents et la différence de tension entre le potentiel de charge d'entrée (VIN) et le potentiel de charge de sortie (VOUT) chute en-dessous d'une valeur de seuil prédéfinie, et
- ledit circuit de charge (1.3) comprenant au moins un commutateur à semi-conducteur et au moins une résistance de puissance qui, connectés en série, forment la connexion secondaire entre le potentiel de charge d'entrée (VIN) et le potentiel de charge de sortie (VOUT), ledit commutateur à semi-conducteur du circuit de charge (1.3) étant connecté au dispositif de commande de circuit de charge (2.3) par l'intermédiaire d'un optocoupleur afin de commander l'activation ou le verrouillage de la connexion secondaire, et
- ledit dispositif de commande de circuit de charge (2.3) étant conçu pour activer la connexion secondaire en commandant l'optocoupleur du circuit de charge (1.3) lorsque les deux signaux de commutation (12.1, 12.2) entrant dans l'unité de commande (2) sont présents, et
- un potentiel de commutation intermédiaire (VSW12) étant appliqué dans la connexion principale entre le commutateur à semi-conducteur du premier circuit de déconnexion (1.1) et le second circuit de déconnexion (1.2), et
- un potentiel de tension de charge (VCRG) étant appliqué dans la connexion secondaire entre ledit au moins un commutateur à semi-conducteur et la ou les résistances de puissance du circuit de charge (1.3), et
- ledit premier canal de diagnostic (3.1) étant conçu pour signaler une déconnexion appropriée du circuit de charge par l'intermédiaire du premier signal de rétroaction (14.1) si la différence de tension entre le potentiel de tension de charge (VCRG) et le potentiel de charge de sortie (VOUT) dépasse une valeur de seuil prédéfinie et la différence de tension entre le potentiel de charge d'entrée (VIN) et le potentiel de commutation intermédiaire (VSW12) dépasse une valeur de seuil prédéfinie et la différence entre le potentiel de charge de sortie (VOUT) et le potentiel de masse côté charge (GNDP) chute en-dessous d'une valeur de seuil prédéfinie, et
- le second canal de diagnostic (3.2) étant conçu pour signaler une déconnexion appropriée du circuit de charge par l'intermédiaire du second signal de rétroaction (14.2) si la différence de tension entre le potentiel de tension de charge (VCRG) et le potentiel de charge de sortie (VOUT) dépasse une valeur de seuil prédéfinie et la différence de tension entre le potentiel de commutation intermédiaire (VSW12) et le potentiel de charge de sortie (VOUT) dépasse une valeur de seuil prédéfinie et la différence de tension entre le potentiel de charge de sortie (VOUT) et le potentiel de masse côté charge (GNDP) chute en-dessous d'une valeur de seuil prédéfinie.

2. Module de déconnexion selon la revendication 1, **caractérisé en ce que** l'unité de déconnexion (1) comporte également un premier circuit de décharge (1.4) et un second circuit de décharge (1.5) et l'unité de commande (2) comporte également une première commande de circuit de décharge (2.4) pour commander le premier circuit de décharge (1.4) et une seconde commande de circuit de décharge (2.5) pour commander le second circuit de décharge (1.5),
- ledit premier circuit de décharge (1.4) comprenant au moins un commutateur à semi-conducteur et au moins une résistance de puissance qui, connectés en série, forment une première connexion de décharge entre le potentiel de charge de sortie (VOUT) et le potentiel de masse côté charge (GNDP), ledit commutateur à semi-conducteur du premier circuit de décharge (1.4) étant connecté à la première commande de circuit de décharge (2.4) par l'intermédiaire d'un optocoupleur afin de commander l'activation ou le verrouillage de la première connexion de décharge, et ladite première commande de circuit de décharge (2.4) étant conçu pour activer la première connexion de décharge en commandant l'optocoupleur de premier circuit de décharge (1.4) lorsque le premier signal de commutation (12.1) entrant dans l'unité de commande (2) est interrompu, et
- ledit second circuit de décharge (1.5) comprenant au moins un commutateur à semi-conducteur et au moins une résistance de puissance qui, connectés en série, forment une seconde connexion de décharge, qui est connectée en parallèle avec la première connexion de décharge, entre le potentiel de charge de sortie (VOUT) et le potentiel de masse côté charge (GNDP), ledit commutateur à semi-conducteur du second circuit de décharge (1.5) étant connecté à la seconde commande de circuit de décharge (2.5) par l'intermédiaire d'un optocoupleur afin de commander l'activation ou le verrouillage de la seconde connexion de décharge, et ladite seconde commande de circuit de décharge (2.5) étant conçu pour activer la seconde connexion de décharge en commandant l'optocoupleur du second circuit de décharge (1.5) lorsque le second signal de commutation (12.2) entrant dans l'unité de commande (2) est interrompu.

3. Module de déconnexion selon la revendication 2, **caractérisé en ce que** l'ampleur des résistances dans le premier circuit de décharge (1.4) et dans le second circuit de décharge (1.5) est dimensionnée de sorte que les connexions de décharge activées réduisent la tension de charge de sortie (11) à un tiers de la tension de charge d'entrée (10).

4. Module de déconnexion selon l'une des revendications 1 à 3, **caractérisé en ce que** chacun des circuits à semi-conducteur du premier circuit de déconnexion (1.1) et du second circuit de déconnexion (1.2) comporte trois commutateurs à semi-conducteur connectés en parallèle.

5. Module de déconnexion selon l'une des revendications 1 à 4, **caractérisé en ce que** l'unité de déconnexion (1) comporte également un circuit de protection contre les pannes (5) doté d'une connexion de décharge en cas de panne entre le potentiel de charge de sortie (VOUT) et le potentiel de masse côté charge (GNDP), ladite connexion de décharge en cas de panne comportant au moins une résistance de puissance ou deux résistances de puissance connectées en parallèle.

6. Module de déconnexion selon l'une des revendications 1 à 5, **caractérisé en ce que** l'unité de commande (2) comporte également un circuit de protection contre les surcharges (6) qui est connecté à la seconde commande de commutation (2.2) et est conçu pour désactiver la seconde commande de commutation (2.2) lorsque la tension d'alimentation (13) de l'unité d'alimentation en tension (4) chute en-dessous d'une valeur de seuil prédéfinie.

7. Module de déconnexion selon l'une des revendications 1 à 6, **caractérisé en ce que** l'unité d'alimentation en tension (4) comprend un premier convertisseur de tension (IC25) pour convertir la tension d'alimentation (13) en une tension de commande pour l'alimentation en tension de l'unité de commande (2) et de l'unité de diagnostic (3), ainsi que d'autres convertisseurs de tension (DCDC1, DCDC2, DCDC3, DCDC4) pour convertir la tension d'alimentation (13) en tensions de commande de commutateur à semi-conducteur sans potentiel.

8. Module de déconnexion selon la revendication 7, **caractérisé en ce qu'**un circuit de surveillance de température (T) est intégré dans l'unité d'alimentation en tension (4), ledit premier convertisseur de tension (IC25) comportant une entrée de commande à laquelle est connecté le circuit de surveillance de température (T).

9. Module de déconnexion selon la revendication 8, **caractérisé en ce que** le circuit de surveillance de température (T) est constitué de deux ou trois circuits connectés en parallèle, qui comportent chacun une thermistance (NTC1, NTC2, NTC3) pour la détection de la température.

10. Module de déconnexion selon l'une des revendications 1 à 9, **caractérisé en ce que** les valeurs de seuil prédéfinies des différences de tension sont réglées respectivement à une valeur de 4V ± 1V, 8V ± 1V ou 14V ± 1V.
